# EUROPEAN PATENT APPLICATION

(11) **EP 4 815 636 A1**
(43) Date of publication of application: **30.09.2026**
(21) Application number: 25167006.3
(22) Date of filing: 28.03.2025
(51) Int. Cl.: H05K 1/02, H05K 1/18, H01L 23/538

(54) **COMPONENT CARRIER WITH ELECTRONIC COMPONENT AND THICK THERMALLY CONDUCTIVE LAYERS ON BOTH SIDES**

(71) Applicant: AT & S Austria Technologie & Systemtechnik Aktiengesellschaft, 8700 Leoben-Hinterberg (AT)
(72) Inventor: MORIANZ, Mike, 8045 Graz (AT); KASTELIC, Markus, 8740 Zeltweg (AT); WEIS, Gerald, 8600 Bruck an der Mur (AT); EBNER, Claudia, 8583 Edelschrott (AT)
(74) Representative: Dilg, Haeusler, Schindelmann Patentanwaltsgesellschaft mbH

(57) **Abstract**

A component carrier (100) which comprises a stack (102) having a central portion (104) comprising at least one electrically conductive layer structure (106) and at least one electrically insulating layer structure (108), at least one electronic component (110) embedded in the central portion (104) of the stack (102), and an electrically and thermally conductive first layer structure (112) on one side of the central portion (104) and an electrically and thermally conductive second layer structure (114) on an opposing other side of the central portion (104), each of said first layer structure (112) and said second layer structure (114) having a thickness (d1, d2) higher than a thickness (d3) of the at least one electrically conductive layer structure (106) of the central portion (104).

## Description

The invention relates to a method of manufacturing a component carrier, and to a component carrier.

In the context of growing product functionalities of component carriers equipped with one or more electronic components and increasing miniaturization of such components as well as a rising number of components to be mounted on or embedded in the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions.

In particular, efficiently removing heat from an embedded electronic component in a component carrier is an issue.

There may be a need to efficiently remove heat from an electronic component in a component carrier.

According to an exemplary embodiment of the invention, a component carrier is provided, wherein the component carrier comprises a stack having a central portion comprising at least one electrically conductive layer structure and at least one electrically insulating layer structure, at least one electronic component embedded in the central portion of the stack, and an electrically and thermally conductive first layer structure on one side of the central portion and an electrically and thermally conductive second layer structure on an opposing other side of the central portion, each of said first layer structure and said second layer structure having a thickness higher than a thickness of the at least one electrically conductive layer structure of the central portion.

According to another exemplary embodiment of the invention, a method of manufacturing a component carrier is provided, wherein the method comprises providing a stack having a central portion comprising at least one electrically conductive layer structure and at least one electrically insulating layer structure, embedding at least one electronic component in the central portion of the stack, and forming an electrically and thermally conductive first layer structure on one side of the central portion and an electrically and thermally conductive second layer structure on an opposing other side of the central portion, each of said first layer structure and said second layer structure having a thickness higher than a thickness of the at least one electrically conductive layer structure of the central portion.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

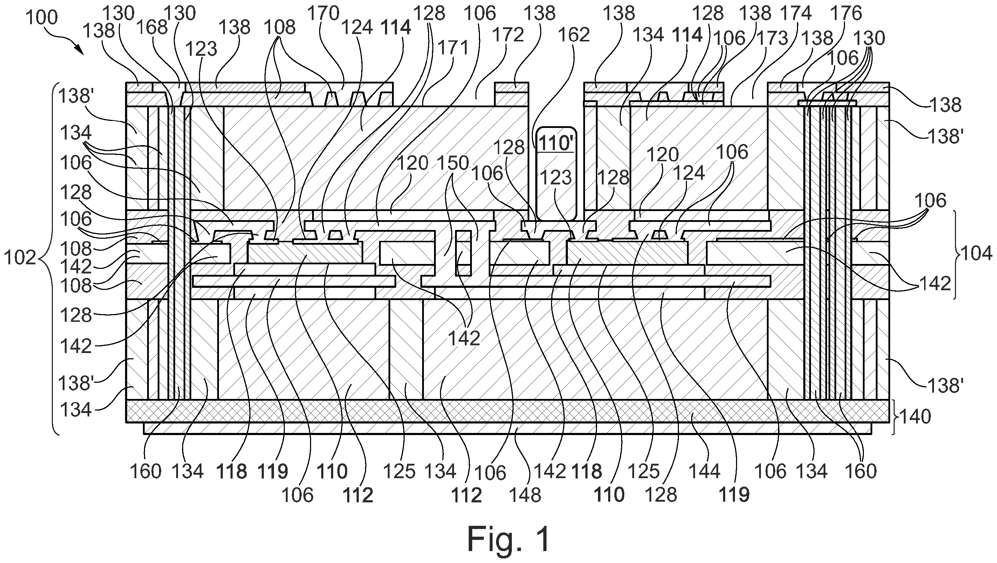

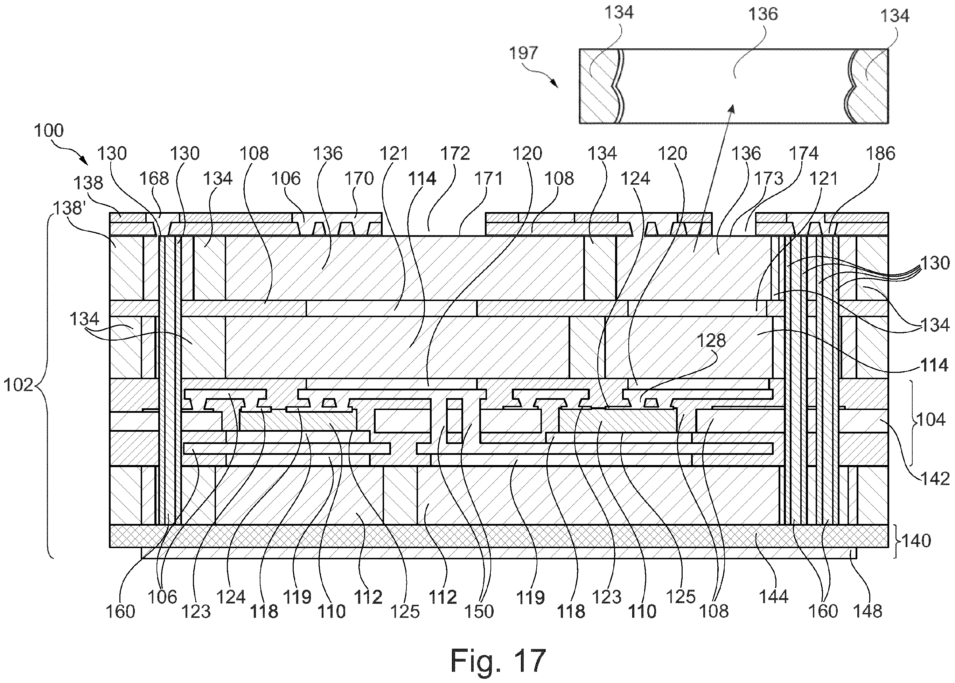

In the context of the present application, the term "central portion of a stack" may particularly denote a section of the stack being vertically spaced with respect to both opposing main surfaces of the stack. For instance, said central portion may be spaced with respect to each of two opposing main surfaces of the stack by at least 10% of the entire stack thickness, in particular at least 20% of the entire stack thickness. Preferably, the central portion of the stack may be located such that the stack is divided in two pieces having the same or substantially the same thickness (see Figure 1). Alternatively, the central portion of the stack may be located such that the stack is divided in two pieces having different thicknesses (see Figure 17). Thus, the central portion may be strictly central or may be shifted in vertical direction with respect to a strict central position. In the latter case, build-ups on both sides of the central portion may be of different thicknesses.

In the context of the present application, the term "layer structure" may particularly denote a continuous layer, a patterned layer or a plurality of nonconsecutive islands within a common plane.

In the context of the present application, the term "electronic component" may particularly denote any component fulfilling an electronic task. For instance, such an electronic component may be a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the semiconductor component may be a semiconductor chip such as a naked die or a molded die.

In the context of the present application, the term "electronic component embedded in the central portion of the stack" may particularly denote that the entire component is at least partially surrounded by stack material of the central portion. In one embodiment, the embedded component is fully circumferentially surrounded by stack material of the central portion. In other embodiments, the embedded component is only partially surrounded by stack material of the central portion, and has another surface portion which is either exposed or covered by other material, for instance peripheral stack material.

In the context of the present application, the term "electrically and thermally conductive layer structure" may particularly denote a (in particular planar) sheet or layer (which may be patterned or continuous) made of a material having a high thermal conductivity and high electrical conductivity. In terms of electrical conductivity, a highly electrically conductive layer structure may have a metallic conductivity, i.e. an electrical conductivity as a metal. For instance, the electrical conductivity of the electrically highly conductive layer structure at 20°C may be at least 5·10⁶ S/m, in particular at least 2·10⁷ S/m. In terms of thermal conductivity, the thermal conductivity of the material of a thermally highly conductive layer structure may be at least 3 W/mK, in particular at least 35 W/mK or at least 100 W/mK. In an example, the electrically and thermally conductive layer structure may comprise copper and/or silver. A respective electrically and thermally conductive layer structure may in particular extend over the entire or at least substantially the entire length and/or width of the stack. The length and/or width of a respective electrically thermally conductive layer structure may be at least five times, in particular at least 10 times, more particularly at least 50 times, of a thickness thereof. Thus, a respective electrically and thermally conductive layer structure may be in contrast to a block or bulk body.

In the context of the present application, the term "thickness of a layer structure" may particularly denote a vertical dimension of said layer structure. In particular, said thickness may be a continuous, average or maximum thickness of the respective layer structure.

In the context of the present application, the term "main surface" of a body may particularly denote one of two largest opposing surfaces of the body or outermost opposing surfaces of the body. The main surfaces may be connected by circumferential side walls. The thickness of a body, such as the component carrier or the stack, may be defined by the distance between the two opposing main surfaces.

According to an exemplary embodiment of the invention, a component carrier is provided which has embedded in an interior thereof one or more electronic components such as silicon chips, and highly conductive thick layer structures sandwiching the component(s) in between. Advantageously, the embedded electronic component(s) and the electrically and thermally conductive exterior layer structures may be thermally and/or electrically coupled with one another. By taking this measure, it is efficiently possible to conduct electricity and/or heat from the electronic component(s) generated during operation of the component carrier away from an interior of the component carrier (in particular up to a periphery) via highly conductive layer structures with low electric resistance and/or low thermal resistance and with short thermal and/or electric path(s). This improves the electric performance and/or the thermal performance and thus the overall reliability of the component carrier since undesired effects such as the generation of thermal stress and consequently undesired phenomena such as warpage may be strongly suppressed. In particular, when electrically coupling one or more embedded electronic components and layer structures attached to opposing sides of a central stack portion, extremely high electric current (for example of 100 Ampère or more) can be conducted through the horizontally extended layer structures without excessive heating of the component carrier. It may also be possible to use the layer structures synergistically to remove considerable amount of heat generated by such a high current operation of the component carrier, in particular when the at least electronic component is a power semiconductor chip. Highly advantageously, an exemplary embodiment may embed one or more electronic components in an interior of a laminated layer stack which results in a simple manufacturing process, a compact design of the component carrier, a proper mechanical protection of the embedded electronic component(s), and an excellent removal of heat created by the electronic component(s) during operation of the component carrier. Said excellent thermal performance of the component carrier may be promoted by cooling the electronic component(s) on each of two respective opposing main surfaces thereof using a pair of thermally conductive and electrically conductive layer structures attached (preferably by lamination) above and below the central portion of the stack having the electronic component(s) embedded therein. Hence, heat removal paths may be established for each electronic component not only in one direction, but simultaneously in two opposing directions up to both exterior main surfaces of the component carrier. Beneficially, the described manufacturing architecture and component carrier design may enable to transport high current with efficient cooling simultaneously. By attaching sufficiently thick electrically and thermally conductive layer structures (such as metal sheets or foils) on two opposing sides of a central portion of a (preferably laminated) layer stack, bulky copper inlay cores may be omitted, which may further improve the ease of manufacture, in particular of power modules, and may simultaneously increase design flexibility. Advantageously, one or more thinner interior electrically conductive layer structures of the stack may be combined with thicker electrically and thermally conductive layer structures outside of an interior portion of the stack, so that a high thermal performance and high current carrying capability can be combined with a compact design.

In the following, further exemplary embodiments of the manufacturing method, and the component carrier will be explained.

In an embodiment, the stack comprises the electrically and thermally conductive first layer structure on one side of the central portion and the electrically and thermally conductive second layer structure on the other side. This may allow efficient cooling and efficient current transmission on both sides of the component carrier. Alternatively, the electrically and thermally conductive first layer structure and the electrically and thermally conductive second layer structure may be provided on one side of the central portion.

In an embodiment, at least one of the first layer structure and the second layer structure comprises at least two sub-structures separated from each other. In particular, one or more electrically insulating barriers (such as trenches or dielectric regions) may be inserted between different laterally adjacent sections of a respective one of the first and the second layer structure so that different sections of a respective layer structure can be galvanically separated to provide separate electric functionality. This may allow to provide a component carrier with sophisticated electric functions while simultaneously keeping the component carrier compact.

In an embodiment, the at least one electronic component is electrically connected to one of the first layer structure and the second layer structure. In particular, electric signal supply and/or electric power or current supply may be accomplished by a respective one of the first and second layer structures.

In an embodiment, the at least one electronic component is electrically connected to a sub-structure of the first layer structure and to a sub-structure of the second layer structure. In particular, different electrically conductive areas, such as pads, of a respective electronic component may be connected to the first and the second layer structures. This may be advantageous in particular for electronic components having conductive areas, such as pads, on both opposing main surfaces thereof.

In an embodiment, a sub-structure of one of the first layer structure and the second layer structure and being electrically connected to the at least one electronic component is configured as a current port, in particular a direct current port. Thus, a direct current (DC) may be supplied to the at least one electronic component via one of the first and second layer structures, having a significant amount of metal. Hence, a high current carrying capability may be achieved allowing to supply to the at least one electronic component even very large direct current values, for example more than 100 A.

In an embodiment, the component carrier comprises at least one conductive connecting layer, in particular an electrically conductive paste, connecting the at least one electronic component with at least one of the first layer structure and the second layer structure. The connection of an electronic component with a layer structure (such as any of the above mentioned first and/or second layer structures, or an electrically conductive layer structure) via a conductive connecting layer, i.e. a spatially extended connecting structure, may provide a low-ohmic connection leading to low losses and low heat dissipation. For instance, the conductive connecting layer may be made of an electrically conductive paste, such as a sinter paste, which simplifies the manufacturing process. In particular, manufacture of the component carrier may be accomplished in a simple way by sinter lamination. Alternatively, a respective conductive connecting layer may also be realized as a solder layer. In an example, the at least one conductive connection layer may be in direct contact with the electronic component. Additionally or alternatively, the at least one conductive connection layer may be free from direct contact with the electronic component. In an example, the lateral extension of the conductive connection layer may be different, in particular larger or smaller, than the lateral extension of the electronic component and/or the first layer structure and the second layer structure. In another example, the lateral extension of the conductive connection layer may be the same as the lateral extension of the electronic component and/or the first layer structure and the second layer structure. In an embodiment, the component carrier comprises at least two conductive connecting layers electrically connecting the at least one electronic component with one of the first layer structure and the second layer structure, wherein in particular one of said at least two conductive connecting layers is directly connected to the at least one electronic component and/or one of the at least one electrically conductive layer structure of the stack separates said at least two conductive connecting layers. By providing plural of the aforementioned conductive connecting layers, the advantageous low-ohmic and low heat dissipating effects of said layer-type conductive connecting structures as well as the simple manufacturability, preferably by sinter lamination, may be achieved over a larger portion of the component carrier.

In an embodiment, the at least one electronic component is electrically connected to the other one of the first layer structure and the second layer structure by a further conductive connecting layer, in particular being directly connected to the other one of the first layer structure and the second layer structure. Respective conductive connecting layers may have different lateral extension and/or width. For example, the lateral extension of the conductive connection layer provided at one side of the electronic component may be different than the lateral extension of the conductive connection layer provided at the other opposed side of the electronic component. In another example, the lateral extension of the conductive connection layer provided at one side of the electronic component may be the same as the lateral extension of the conductive connection layer provided at the other opposed side of the electronic component. Such parameters may be selected in accordance with a desired function of the respective conductive connecting layer in the framework of the component carrier.

In an embodiment, the at least one electronic component comprises at least two electronic components embedded in the central portion, in particular connected with each other by at least one of the at least one electrically conductive layer structure of the central portion. Optionally, the at least two electronic components embedded in the central portion may be connected with each other by at least one conductive connection layer. For example, different electronic components may be arranged side-by-side, in particular at the same vertical level. In particular, it may be possible to embed different electronic components in through holes of the same core. By providing plural electronic components being interconnected with each other, even sophisticated electronic functions may be provided, for instance a half bridge function or a sixpack function.

In an embodiment, the at least one electronic component comprises at least two electronic components embedded in the central portion, in particular connected with each other by one of the first layer structure and the second layer structure. In particular when arranging the electronic components all embedded in the central portion of the stack sandwiched between two thick metal sheets, very short electric paths between the exterior layer structures and the central electronic components may be achieved. This may lead to low loss, low heat dissipation and high signal integrity.

In an embodiment, said one of the first layer structure and the second layer structure is configured as a current port, in particular an alternating current port. Hence, an alternating current (AC) may be carried by a respective one of the thick layer structures.

In an embodiment, the at least one electronic component comprises at least two electronic components embedded in the central portion, wherein a top surface of a first of said electronic components is electrically connected to a bottom surface of a second of said electronic components, in particular is electrically connected by at least one vertical through connection at least partially extending through the central portion. When the electronic components are arranged side-by-side in the central portion, an interconnection of a top main surface of one of said electronic components with a bottom main surface of the other of said electronic components may be accomplished in a smart way by the electrically conductive layer structures of the stack. In particular, at least one vertical through connection, such as a copper pillar or a metal-filled mechanically drilled via, may be arranged laterally between the electronic components to accomplish their connection in vertical direction, whereas patterned metal layers may ensure coupling within a horizontal plane.

In an embodiment, the at least one electronic component comprises two main surfaces, one main surface comprising a conductive area, in particular two conductive areas, and the other main surface comprising at least one further conductive area. In particular, said conductive areas may be pads or terminals of a chip-type electronic component. In an example, the conductive areas may comprise metal, in particular copper. In another example, the conductive area provided on one main surface is different, in particular smaller, than the further conductive area provided on other main surface. When one or more conductive areas (such as pads) are provided on each of the two opposing main surfaces of a respective electronic component, said electronic component may be embodied as a vertical device experiencing a vertical current flow during operation. For instance, the electronic component may be a field-effect transistor chip which may have a source pad and a gate pad on one main surface and a drain pad on an opposing other main surface.

In an embodiment, at least one of the two conductive areas and the further conductive area is connected to at least one of the first layer structure and the second layer structure, in particular through at least one conductive connecting layer, more particularly through at least one conductive connecting layer comprising a paste. Hence, electric signals and/or electric power may be transmitted between a respective one of the layer structures and a corresponding conductive area of the respective electronic component.

In an embodiment, at least one of the at least one electrically insulating layer structure, in particular a core, at least partially defines a cavity in which the at least one electronic component is embedded, wherein at least one of the at least one electrically conductive layer structure is provided on said at least one of the at least one electrically insulating layer structure and is electrically connected to at least one conductive area of the at least one electronic component. A core may be a rigid sheet of cured dielectric material (such as FR4), and may comprise a patterned metal layer thereon. A through hole or a blind hole in such a core may accommodate a respective electronic component. Said patterned metal layer may contribute to the electric interconnection with the component carrier. The core may form a base or center of the central portion of the stack. Advantageously, a component carrier according to an exemplary embodiment may comprise only a single core, which may promote a simple manufacturing process and may lead to a compact design.

In an embodiment, the at least one of the at least one electrically conductive layer structure is electrically connected to one of two conductive areas on one main surface of the at least one electronic component. In particular, a chip pad may be connected with an electrically conductive layer structure of the stack for interconnecting the assigned electronic component.

In an embodiment, the at least one of the at least one electrically conductive layer structure is electrically connected to at least one conductive area of the at least one electronic component through vertical connections, in particular vias. Thus, a vertical interconnection of a conductive area of an electronic component may be accomplished by a vertical through connection, whereas a horizontal interconnection may be realized by a patterned horizontal electrically conductive layer structure.

In an embodiment, the at least one of the at least one electrically conductive layer structure is arranged next to the cavity (in particular in stacking direction and/or in lateral direction), in particular without any further electrically conductive structures in between. Additionally or alternatively, the at least one of the at least one electrically conductive layer structure is arranged next to the at least one electronic component. Such a configuration may keep the electric connection paths short, so that a compact design may be combined with low losses and high signal quality.

In an embodiment, the component carrier comprises a vertical through connection passing vertically through at least part of the stack, in particular the central portion, and being electrically connected to an electrically conductive area of the at least one electronic component. For instance, such a vertical through connection may be a metal-filled mechanically drilled blind hole or through hole. It may however also be a metal pillar, such as a copper pillar.

In an embodiment, the vertical through connection forms a signal port for providing a control signal to the at least one electronic component. Thus, an electric control signal may be supplied to a controlling conductive area, such as a gate pad, of a respective one of the at least one electronic component by the vertical through connection. Supplying such a low-power control signal can be executed via a vertical through connection and thus apart from the high metal volume layer structures, which may be responsible for electric power supply or transmission.

In an embodiment, the vertical through connection is electrically connected to the electrically conductive area through at least one of the at least one electrically conductive layer structure. In particular, a combination of a vertical through connection and one or more horizontally oriented electrically conductive layer structures of the central portion may accomplish electric signal supply.

In an embodiment, the vertical through connection is electrically insulated with respect to at least one of the first layer structure and the second layer structure. By this electric separation of paths, the vertical through connection can take care about control signal management, whereas the high metal volume first and second layer structures may care about electric power management.

In an embodiment, the vertical through connection passes through an electrically insulating clearance structure separating sub-structures of the first layer structure and/or the second layer structure. Such an electrically insulating clearance structure may comprise or consist of one or more electrically insulating blocks arranged within the respective first or second layer structure for dividing or separating the latter into sub-structures or sections at different electric potentials. In addition, the electrically insulating clearance structure may function as dielectric matrix for guiding the above mentioned vertical through connection through the stack, in particular for managing electric signal supply to the at least one electronic component. In an example, the electrically insulating clearance structure may comprise organic polymeric material, for example epoxy resin. In another example, the electrically insulating clearance structure may be different from (in particular may be made from a different material than) the at least one electrically insulating layer structure.

In an embodiment, the at least one electronic component comprises two conductive areas which are connected with the first layer structure and/or the second layer structure. In particular, all electric power carrying conductive areas of the electronic component (for instance source pad and drain pad of a field-effect transistor chip-type electronic component) may be connected with the high metal content first and/or second layer structure. Such electric current carrying conductive areas of the at least one component may be arranged on two opposing main surfaces thereof.

In an embodiment, the at least one electronic component comprises a main surface with two conductive areas only one of which being connected with one of the first layer structure and the second layer structure. For instance, a source pad and a gate pad may be formed on the same main surface of a field-effect transistor chip-type electronic component, and only the source pad, not the gate pad, may be connected with one of the high metal content first and second layer structures. The gate pad may be connected with an electrically separate vertical through connection which may be electrically decoupled from the first and second layer structures. A drain pad on an opposing main surface of the electronic component may be operated in cooperation with one of the first layer structure and the second layer structure.

In an embodiment, a thickness of a respective one of the first layer structure and the second layer structure is in a range from 200 µm to 500 µm or is in a range from 400 µm to 1000 µm. Also a range from 200 µm to 800 µm is possible for any of the first layer structure and the second layer structure. Thus, the first layer structure and the second layer structure may be embodied as thick metal sheets having a significantly larger thickness than each of the one or more electrically conductive layer structures of the central portion of the stack. For example, any of said electrically conductive layer structures may have a thickness in a range from 20 µm to 100 µm, in particular from 30 µm to 80 µm. By forming the first and second layer structures of very thick metal sheets, such as copper foils, they can properly fulfill their current carrying and heat dissipating function on both opposing main sides of the central portion of the stack. Thus, efficient cooling may be combined with a high current carrying and thus high power capability of the component carrier. In an example, the thickness of the first layer structure may be the same as the thickness of the second layer structure. In another example, the thickness of the first layer structure may be different from the thickness of the second layer structure.

In an embodiment, sub-structures of at least one of the first layer structure and the second layer structure are separated by at least one electrically insulating clearance structure, in particular so that a resulting electric path is exclusively for signal routing. Such an electrically insulating clearance structure may be configured as one or more dielectric blocks extending through the first layer structure and/or the second layer structure for dividing them into sub-structures. An electrically conductive vertical through connection may be guided through the electrically insulating clearance structure for providing a signal supply path for the at least one electronic component. The formation of the electrically insulating clearance structure may lead to galvanically separated sub-structures of the respective first and second layer structure, so that each of them may be used more efficiently for providing sophisticated electronic functions. At the same time, an electrically insulating clearance structure may be used for guiding a vertical through connection through the stack, electrically isolated from the first and second layer structures.

In an embodiment, the clearance structure extends vertically up to the central portion for completely separating sub-structures of at least one of the first layer structure and the second layer structure. Hence, for forming the clearance structure it may be sufficient to form one or more trenches in the first and/or second layer structures and to fill them with dielectric material, while the central portion of the stack may remain uninfluenced.

In an embodiment, the clearance structure extends vertically into a part of at least one of the first layer structure and the second layer structure. In particular, the clearance structure may extend vertically only through a vertical sub-portion of the first layer structure or the second layer structure, whereas another vertical sub-portion of the first layer structure or the second layer structure may be free of the clearance structure. For example, the clearance structure may extend through the entire thickness of the respective first or second layer structure, in particular up to the central portion of the stack. By filling at least part of a respective through hole of the clearance structure with an electrically conductive material an electric coupling with the central portion of the stack may be possible, in particular terms of electric signal supply management.

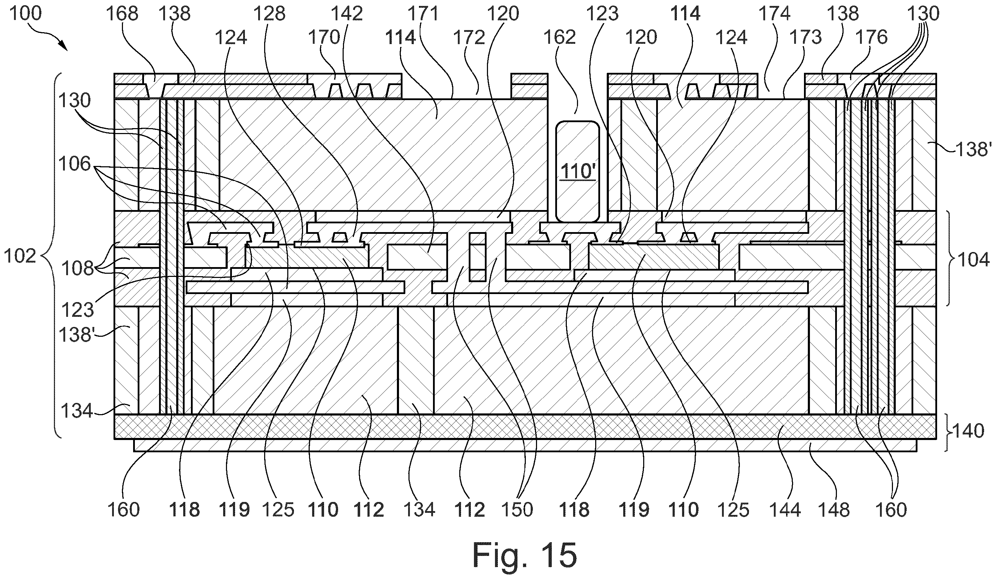

In an embodiment, an external element, in particular an external component, is at least partially provided in the clearance structure. For example, a cavity, blind hole or through hole may be formed in the clearance structure and may accommodate an external component, for instance a temperature sensing component (see for example reference sign 110' in Figure 15). More specifically, at least one surface mounted device may be arranged on a surface of the clearance structure, for instance in a trench extending into the clearance structure. Such an architecture may be ideal for accommodating a temperature sensor-type external component in the clearance structure and very close to the at least one electronic component embedded in the central portion of the stack and being a main heat source of the component carrier, for precise temperature monitoring by the external component. Additionally or alternatively, it may be also possible to provide at least one surface mounted component (such as an active device, like a transistor chip, or a passive device, such as an inductor) on an exterior main surface of the component carrier.

In an embodiment, the clearance structure comprises an electrically insulating and thermally conductive material. For instance, the clearance structure may be made of a thermal prepreg or of a ceramic material. In addition to its electrically insulating function, the clearance structure may then also contribute to heat removal.

In an embodiment, a volume percentage between one of the first layer structure and the second layer structure and the clearance structure in respect to the one of the first layer structure and the second layer structure is higher than a volume percentage of the at least one electrically conductive layer structure of the central portion and the at least one electrically insulating layer structure of the central portion. Specifically, the metal content in the first and second layer structure may be larger than the metal content in the central portion of the stack. This may enable the first and second layer structure to support high current carrying capability and efficient cooling of the component carrier in view of a significant amount of heat generated by the at least one embedded electronic component during operation.

In an embodiment, a volume percentage between one of the first layer structure and the second layer structure and a sum of the one of the first layer structure and the second layer structure and the clearance structure in respect to the one of the first layer structure and the second layer structure is at least 80%. In an embodiment, the ratio may be even at least 90%. Hence, a metal content of the first or second layer structure may be very high, which may have a positive impact on its heat dissipation capability and on its current carrying capability.

In an embodiment, a thickness of one of the first layer structure and the second layer structure is larger than a thickness of the other one of the first layer structure and the second layer structure. Such a different thickness architecture of the two exterior attached (for instance metal sheet-type) first and second layer structures may allow to individually adjust thickness of the first and the second layer structure in accordance with its specific requirements for a certain electronic and thermal application. Alternatively, the thicknesses of the first and second layer structures may be identical.

In an embodiment, the stack is vertically asymmetrically. In particular, a build-up on one side of the central portion may be different from a build-up on the other side of the central portion. Thanks to the excellent heat dissipation capability of the component carrier, even an asymmetric stack build-up may be possible without the risk of undesired phenomena such as warpage or delamination.

In an embodiment, the component carrier comprises an electrically and thermally conductive third layer structure on or above one of the first layer structure and the second layer structure. In particular, an additional thick metal layer (such as a further copper sheet) may be attached on an exterior surface of the first layer structure or the second layer structure. Such a third layer structure may have the properties (for instance in terms of absolute and relative thickness and/or concerning the provision of an electrically insulating clearance structure and/or concerning its electric function in the framework of the component carrier) of the first or second layer structure, as described herein. By stacking the first or second layer structure with a third layer structure, the electric current capability and/or the heat removal capability may be locally enhanced in the component carrier. For instance, a single layer structure may be arranged on a side of the component carrier at which a heat sink will additionally contribute to heat dissipation, whereas the opposing side may be made fit for efficient heat removal by stacking two thick metal layer structures.

In an embodiment, the third layer structure is connected with said one of the first layer structure and the second layer structure by at least one conductive connecting layer, in particular comprising a conductive paste. Such an electrically conductive paste may be a sinter paste. Thus, connection of the third layer structure may also become possible by sinter lamination. Alternatively, the conductive connecting layer may comprise a solder material.

In an embodiment, the third layer structure is electrically connected to at least one of the at least one electronic component. Thus, also the third layer structure may contribute to the electronic functionality of the component carrier, in particular to electric power management.

In an embodiment, the third layer structure is electrically decoupled from the other one of the first layer structure and the second layer structure. In particular, a stack of two high metal volume layer structures may be formed on one side of the central portion of the stack, whereas the other side of the central portion of the stack may have only a single high metal volume layer structure thereon.

In an embodiment, the first layer structure and the second layer structure are configured for providing a power function during operation of the component carrier. Thanks to their large thickness, the first and second layer structures are ideal for conducting a high current and for efficiently removing generated heat, in particular in the context of a power package application.

In an embodiment, one of the first layer structure and the second layer structure being directly connected to one main surface of one of the at least one electronic component is configured for providing only a power function during operation of the component carrier. Thus, such a layer structure may be designed specifically for conducting, providing and/or conveying electric power, whereas an electric signal supply may be arranged apart from such a layer structure.

In an embodiment, the at least one electronic component is an active component, in particular a transistor component, more particularly a field-effect transistor component, even more particularly a metal oxide semiconductor field-effect transistor component. For instance, the respective electronic component may be a power semiconductor chip. It may however also be a logic chip. As an alternative to a transistor function, the electronic component may fulfil another function, such as a diode function.

In an embodiment, a main surface of the stack comprises a surface protection layer. In particular, such a surface protection layer may be provided on one or both opposing main surfaces of the stack. A suitable surface protection layer is a patterned solder resist layer protecting surface portions of the component carrier against oxidation and undesired accumulation of solder material.

In an embodiment, a further surface protection layer is provided on lateral sides of the stack. In particular, such a sidewall-protecting surface protection layer of the component carrier may be a dielectric sidewall coverage for electrically protecting the component carrier sideways against undesired current paths. For example, such a further surface protection layer may be formed as part of an electrically insulating clearance structure, as described herein.

In an embodiment, an outermost structure of the stack comprises a thermally conductive and electrically insulating layer, in particular a ceramic layer or a thermal prepreg. This may further promote heat dissipation out of the component carrier on one side.

In an embodiment, the outermost structure is configured to be coupled with a heat sink and/or a chassis. For example, a heat sink may comprise a thermally conductive plate connected to the outermost structure, wherein a plurality of thermally conductive cooling fins extend from said thermally conductive plate. For instance, such a heat sink may be made of a metal (for instance copper or aluminum) and/or a ceramic (for example aluminum nitride).

In an embodiment, the thermally conductive and electrically insulating layer is covered by a metal layer. This may enable soldering of a heat sink or the like to an exterior surface of the outermost structure.

In an embodiment, the outermost structure has a fragmental surface, in particular comprising a heat sink and a planar surface, and optionally at least one further component. Hence, even more sophisticated thermal and/or electrical arrangements may be provided at an exterior surface of the outermost structure.

In an embodiment, at least one of the first layer structure and the second layer structure is formed by a patterned conductive layer provided on a respective side of the central portion. Voids of such a patterned conductive layer may be partially or entirely filled with a dielectric material, thereby forming for instance the electrically insulating clearance structure as described herein.

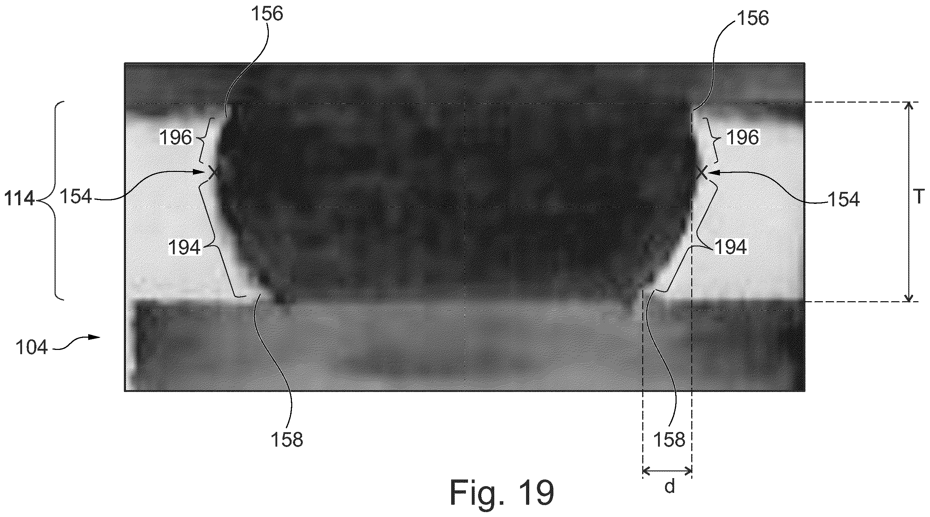

In an embodiment, the patterned conductive layer comprises lateral walls with a vertically intermediate enlargement feature between two vertical extremities. In an embodiment, the patterned conductive layer comprises lateral walls with a first slanted portion slanted towards the central portion of the stack. In an embodiment, the patterned conductive layer comprises lateral walls with a second slanted portion slanted facing away from the central portion of the stack. In an embodiment, an extension of the first slanted portion is greater than that of the second slanted portion, in particular at least a factor of three greater. In an embodiment, the patterned conductive layer comprises lateral walls having a concave shape. In an embodiment, the patterned conductive layer comprises lateral walls in accordance with the condition d≥T/4, wherein d is a horizontal offset of an extremity of the patterned conductive layer on the central portion of the stack with respect to the opposed extremity facing away from the central portion, and T is a thickness of the patterned conductive layer. For these embodiments, reference is made in particular to Figure 19. Such a geometry may be formed by etching or a combination of routing and etching. The mentioned geometric features may lead to an anchoring of the respective layer structure in the framework of the component carrier, which may suppress undesired phenomena such as warpage and delamination.

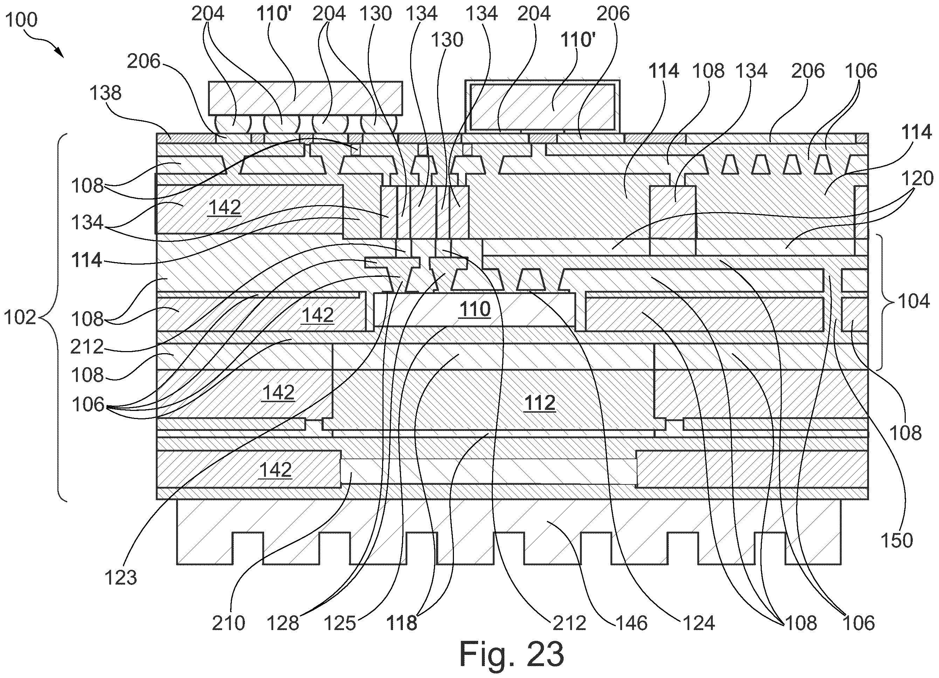

In an embodiment, the component carrier comprises at least one vertical through connection passing vertically through an electrically insulating clearance structure in the second layer structure for vertically electrically connecting at least one electrically conductive area of the at least one electronic component. Such an embodiment is shown for instance in Figure 23. By such a purely vertical connection and electric signal supply, very short current paths are possible. This may lead, in turn, to low losses, low heat dissipation and high signal integrity. In particular, a concentric metallic structure (which may be composed of one or more metallic sub-components, such as at least one cylindrical metallic structure, at least one frustoconical metallic structure, at least one metallic solder structure and/or at least one metallic pad) may be provided for electrically accessing an embedded conductive area of an electronic component embedded in a central portion of the stack. In particular, this may lead to a highly efficient electric signal supply.

In an embodiment, the at least one electrically conductive area of the at least one electronic component comprises a gate pad and/or a source pad. Thus, electric signal supply and/or electric power management may be accomplished via the described purely vertical connection.

In an embodiment, the at least one vertical through connection comprises two parallel vertical through connections for vertically electrically connecting at least one, in particular two, electrically conductive areas on one main surface of one electronic component. In particular, the at least one vertical through connection comprises two parallel vertical through connections for vertically electrically connecting two electrically conductive areas on the same main surface of the same electronic component. For instance, two parallel electric paths may extend through an electrically insulating clearance structure from an exterior side of the component carrier up to the embedded component with its two conductive areas on the same main surface. This may lead to a compact and efficient electric connection.

In an embodiment, the at least one vertical through connection passes entirely vertically from an uppermost electrically conductive layer structure of the stack up to the at least one electrically conductive area. This may result in extremely short electric paths between an exterior main surface of the component carrier and the conductive areas of the embedded electronic component.

In an embodiment, the at least one vertical through connection comprises an electrically conductive sleeve filled with an electrically conductive paste. For instance, the electrically conductive path may be formed by plating a through hole in the dielectric stack material. A remaining void may be filled with an electrically conductive paste. This may allow to create a low-ohmic structure in a fast manufacturing process.

In an embodiment, the at least one vertical through connection comprises electrically conductive paste directly surrounded by the electrically insulating clearance structure. Thus, also an entire hole in a dielectric structure of the stack may be filled by electrically conductive paste.

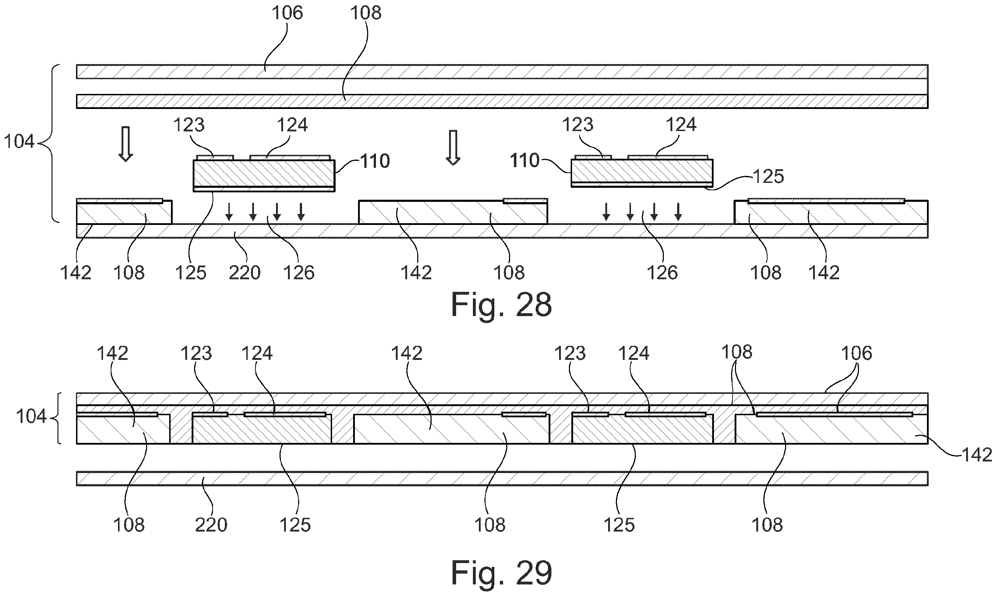

In an embodiment, the embedding of the at least one electronic component in the central portion of the stack comprises accommodating the at least one electronic component in an accommodation volume (or cavity) defined between sidewalls of a patterned at least one electrically insulating layer structure and a main surface portion of an adhesive temporary carrier attached to a bottom main surface of said patterned at least one electrically insulating layer structure, fixing in place the at least one electronic component in the accommodation volume, in particular by laminating an at least partially uncured further electrically insulating layer structure on the at least one electronic component, and after removing the temporary carrier, attaching a conductive connecting layer, in particular a sinter paste, to an exposed main surface of the at least one electronic component. Such an embodiment is illustrated in Figure 28 to Figure 31. Beneficially, the mutual positioning between the conductive connecting layer (for example sinter paste) and the at least one electronic component may be highly precise. Since this manufacturing architecture omits the need to pick and place the electronic component on the sinter paste, a very accurate alignment may be ensured.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB or being plugged in a socket mounted on a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing layer structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, highfrequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium, molybdenum and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 to Figure 11 illustrate cross-sectional views of structures obtained during carrying out a method of manufacturing a component carrier, shown in Figure 1, according to exemplary embodiments of the invention.
Figure 12 to Figure 15 illustrate cross-sectional views of structures obtained during carrying out a method of manufacturing a component carrier, shown in Figure 15, according to another exemplary embodiment of the invention.
Figure 16 to Figure 17 illustrate cross-sectional views of structures obtained during carrying out a method of manufacturing a component carrier, shown in Figure 17, according to another exemplary embodiment of the invention.
Figure 18 illustrates a cross-sectional view of a component carrier according to another exemplary embodiment of the invention.
Figure 19 to Figure 22 illustrate cross-sectional images of structures obtained during carrying out a method of manufacturing a component carrier according to another exemplary embodiment of the invention.
Figure 23 illustrates a cross-sectional view of a component carrier according to another exemplary embodiment of the invention.
Figure 24 illustrates a cross-sectional view of a component carrier according to another exemplary embodiment of the invention.
Figure 25 illustrates a cross-sectional view of a component carrier according to another exemplary embodiment of the invention.
Figure 26 illustrates a cross-sectional view of a component carrier according to another exemplary embodiment of the invention.
Figure 27 illustrates a plan view of part of the component carrier according to Figure 26.
Figure 28 to Figure 31 illustrate cross-sectional views of structures obtained during carrying out a method of manufacturing a component carrier according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Known power modules may be manufactured with two separate copper-inlay cores and discrete copper inlays. There may still be room for improvement in terms of compactness, manufacturing effort and flexibility of design of component carriers.

According to an exemplary embodiment of the invention, a component carrier (for example a printed circuit board or an integrated circuit substrate) has a (preferably laminated layer) stack with a central portion having one or more electrically conductive layer structures. Moreover, one or more electronic components, such as power dies, may be embedded in the central stack portion. Both electrically and thermally conductive layer structures may be arranged on both opposing sides of the central portion. Advantageously, said exterior layer structures may be thicker than the one or more interior electrically conductive layer structure of the central portion. With such a manufacturing architecture, no or not only bulky copper inlay cores may be provided, but in contrast to this thicker electrically and thermally conductive layer structures may be foreseen. Beneficially, this may further simplify the manufacturing process, for instance for semiconductor power applications. Also, an enhanced flexibility of defining a component carrier design may be obtained. Advantageously, thinner interior electrically conductive layer structures and thicker exterior electrically and thermally conductive layer structures may be provided in combination, allowing to achieve excellent properties in terms of electric performance and thermal reliability while simultaneously obtaining a compact design.

Advantageously, component carriers according to exemplary embodiments may provide an excellent ease of manufacture. In particular, when embodied as a component carrier-type power module, such component carriers may advantageously replace copper inlay cores by attaching comparatively thick electrically and thermally conductive layer structures of both sides of a central stack portion. Beneficially, such a manufacturing process may further increase the design flexibility for component carriers, in particular for component carriers with power module functionality.

According to exemplary embodiments, a lamination process may be full area distributed over a stack surface. Therefore, a risk of an unfavorable pressure distribution in an actual lamination process may be advantageously avoided. Furthermore, a risk of degradation of an inlay core material may be prevented by omitting bulky electrically and thermally conductive inlays in exemplary embodiments. Contrary to conventional manufacturing processes of component carriers involving discrete copper inlay and core manufacturing processes, quality risks may be prevented when attaching comparatively thick thermally and conductive layer structures to both opposing sides of a central stack portion. Moreover, exemplary embodiments may allow to achieve a high flexibility in component carrier design. The manufacturing architecture of exemplary embodiments may also allow to create customized power modules with embedded components like SiC and GaN. Beyond this, the solid performance of a component carrier using copper inlays is limited by the limited thickness of a copper inlay of for example 600 µm, 800 µm or 1000 µm. However, when attaching comparatively thick thermally and electrically conductive layer structures to both opposing sides of a central portion of the stack, the large horizontal area of such sheet or layer structures (for instance embodied as metal foils) may provide excellent electric and thermal performance while simultaneously keeping the component carrier compact in a vertical direction. For instance, with a chip on foil architecture, the copper thickness can be adjusted over a wide range, for instance between 200 µm and 800 µm. Therefore, applications requiring high current carrying capability, for example at least 200 Ampère or even up to 1000 Ampère can be realized.

Further advantageously, the overall manufacturing effort of a power module-type component carrier may be significantly reduced by exemplary embodiments. In particular, this may be achieved by eliminating high effort processing stages such as soft lamination. Furthermore, it may be possible according to exemplary embodiments to reduce the complexity of a stack build-up by using a relatively thick copper foil for the two exterior attached thermally and electrically conductive first and second layer structures, so that building a multi-layer and inserting copper inlays may be dispensable. In particular, a high process efficiency may be achieved by exemplary embodiments.

In an embodiment, a component carrier may be provided which comprises a stack comprising a central portion comprising at least one electrically conductive layer structure and a plurality of electrically insulating layer structures, at least one component embedded in the central portion, two electrically and thermally conductive structures respectively provided on both sides of the central portion, each of said two electrically and thermally conductive structures having a thickness higher than the thickness of the at least one electrically conductive layer structures of the central portion.

In an embodiment, at least one of the two electrically and thermally conductive structures comprises at least two structures divided (in particular physically divided) with respect to each other. For example, the least one component may be connected to one of the two electrically and thermally conductive structures. In particular, the least one component may be connected to a respective one of the two electrically and thermally conductive structures and to the other one of the two electrically and thermally conductive structures. For example, one or more structures connected to the component is configured as a current port of the stack (for instance a direct current port, such as DC- or DC+). In an embodiment, a structure is connected to the component by at least one conductive connecting layer, in particular of a conductive paste, between the component and the structure. For instance, a structure is connected to the component by two conductive connecting layers, in particular one directly connected to the component and/or with a conductive layer structure dividing said at least two conductive connecting layers. In an embodiment, the component is connected to the structure of the other one of the two electrically and thermally conductive structures by one conductive connecting layer, in particular said conductive connecting layer being directly connected to the structure. For instance, at least two components are embedded in the central portion, in particular connected with each other by the at least one electrically conductive layer structure of the central portion. For example, at least two components are embedded in the central portion, in particular connected with each other by one of the two electrically and thermally conductive structures. In an embodiment, said common electrically and thermally conductive structure may define a connection port of the component carrier (such as an alternating current connection port, AC). For example, the component comprises two main surfaces, one comprising a conductive area, in particular two conductive areas, the other main surface comprising at least one further conductive area. For instance, at least one of the two conductive areas or the further conductive area may be connected to one respective structure, in particular through at least one conductive connecting layer (for instance comprising a paste). In an embodiment, the central portion comprises at least one layer, in particular a core, at least partially defining a cavity where said component is embedded. In particular, one electrically conductive layer structure may be provided on said layer and may be electrically connected to one conductive area of the component. For example, a connection to one of the two conductive areas on one main surface of the component may be established. For example, this may be established through vertical connections (such as vias) and/or an electrically conductive layer structure. In an embodiment, the one electrically conductive layer structure may be provided adjacent to the cavity (in particular with no further conductive structures in between). For instance, the one electrically conductive layer structure may be provided adjacent to the component. In particular, a signal port (for instance corresponding to a gate) of the stack may be connected by a vertical through connection at least partially passing through the stack and connected to one electrically conductive layer structure and the conductive area of the component. In an embodiment, each of the two conductive areas on one main surface of the component are connected to a respective structure. For instance, a thickness of the respective structure may be in a range from 200 µm to 500 µm. Alternatively, a thickness of the respective structure may be in a range from 100 µm to 1000 µm. In an embodiment, only one of the two conductive areas on one main surface of the component is connected to a respective structure. For instance, the vertical through connection is insulated from the structures. In particular, the vertical through connection passes through a clearance separating the structures of a respective one of the two electrically and thermally conductive structures. In case the clearance structure is for routing a gate signal only, it can be an opening as well which is at least partially encircled by at least one of the structures. For example, a thickness of the respective structure may be in a range from 400 µm to 1 mm. In particular, the structures of at least one or both the of the two electrically and thermally conductive structures are separated by at least one clearance. For example, the clearance vertically extends up to the central portion completely separating the adjacent structures. In an embodiment, the clearance partially vertically extends in the respective electrically and thermally conductive structure. For example, an external element and/or an external component is at least partially provided in the clearance. In particular, the clearances are filled by an electrically insulating material, more particularly by an electrically insulating and thermally conductive material. For example, the volume percentage between the electrically and thermally conductive material and the clearances of a respective electrically and thermally conductive structure is higher than the volume percentage of the at least one electrically conductive layer structure of the central portion and the dielectric material between said structure. In an embodiment, the volume percentage of the electrically and thermally conductive material is at least 80% of the entire volume of the electrically and thermally conductive structure with the clearances. For example, one of the two electrically and thermally conductive structures is thicker than the opposite one. In an embodiment, the stack is configured with a vertically asymmetric structure. For instance, an additional electrically and thermally conductive structure is provided on one or both of the two electrically and thermally conductive structures. The additional electrically and thermally conductive structure may be connected with the electrically and thermally conductive structure by at least one conductive connecting layer, in particular of a conductive paste. In an embodiment, a further component may be provided in the central portion. For example, the additional electrically and thermally conductive structure is connected to the further component. In particular, the additional electrically and thermally conductive structure is electrically insulated from the opposed electrically and thermally conductive structures. For example, the two electrically and thermally conductive structures have a power function. In an embodiment, at least one structure for signal transmission is provided. For instance, the one of the two electrically and thermally conductive structures directly connected on one side of the component(s) has a power function only. In an embodiment, the component is an active component, for example a metal oxide semiconductor field-effect transistor (MOSFET). The stack may comprise a surface protection layer. Such a surface protection layer may be foreseen also on the lateral sides of the stack. In an embodiment, one of the outermost layers comprises a thermally conductive and electrically insulating layer (for instance a ceramic). In an embodiment, it may be connected to a heat sink. For instance, it may be covered by an additional copper layer. In an embodiment, it may be a fragmental surface (for example a surface with a heat sink and planar surfaces and optionally one or more other components). For example, at least one, preferably the two, more preferably all the electrically and thermally conductive structures are formed by a patterned conductive foil provided on the respective side of the central portion.

According to an exemplary embodiment, a method of manufacturing a component carrier is provided. Such a method may comprise embedding components using sinter lamination. Furthermore, the core with embedded component may be connected with thick copper foils by sinter lamination. In a third stage, a structuring and a filling of the thick copper foils may take place. Such a manufacturing architecture may replace or supplement conventional inlay cores and metallic inlays by exterior relatively thick thermally and electrically conductive layer structures. This may render the design more flexible and may increase the size of the power modules. Furthermore, the manufacturing effort may be reduced compared with conventional approaches.

Referring to **Figure 1****,** a component carrier 100 according to an exemplary embodiment of the invention is shown.

The illustrated component carrier 100 may be an integrated circuit (IC) substrate or a printed circuit board (PCB). The component carrier 100 may comprise a laminated layer stack 102 comprising electrically conductive layer structures 106 and electrically insulating layer structures 108 in a vertically central portion 104 of the stack 102. For example, the electrically conductive layer structures 106 may comprise patterned metal layers (such as patterned copper foils or patterned deposited copper layers) and vertical through connections, for example copper filled vias, which may be created by drilling and plating. The electrically insulating layer structures 108 may comprise a respective resin (such as a respective epoxy resin), preferably comprising reinforcing particles therein (for instance glass fibers or glass spheres). For example, the electrically insulating layer structures 108 may be made of prepreg or FR4. The electrically insulating layer structures 108 may also comprise resin layers being free of glass (in particular free of glass fibers).

Thus, the component carrier 100 comprises stack 102 having central portion 104 comprising said electrically conductive layer structures 106 and said electrically insulating layer structures 108. According to Figure 1, the stack 102 is vertically asymmetrically.

Two (or more or less) electronic components 110 are embedded in the central portion 104 of the stack 102. For instance, each of said electronic components 110 may be a semiconductor die, for example a semiconductor power die. For instance, any of the electronic components may be a transistor die, for instance a field-effect transistor die such as a MOSFET die. For example, the field-effect transistor die-type electronic components 110 of Figure 1 can be connected as a half bridge.

Furthermore, an electrically and thermally conductive first layer structure 112 is provided on one side, more specifically on the lower main surface, of the central portion 104. Moreover, an electrically and thermally conductive second layer structure 114 is arranged on an opposing other side, more precisely on the top main surface, of the central portion 104.

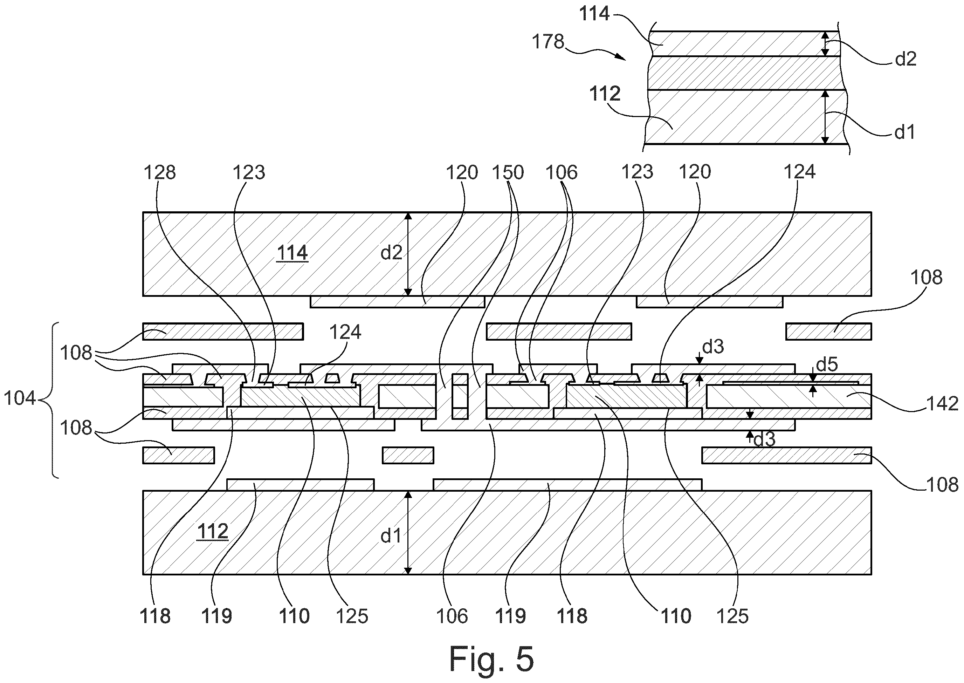

As shown in Figure 5, said first layer structure 112 has a first thickness d1 and said second layer structure 114 has a second thickness d2. Each of the first thickness d1 and the second thickness d2 is higher than a thickness d3 of each individual one of the electrically conductive layer structures 106 of the central portion 104. For instance, first thickness d1 and/or second thickness d2 may be at least twice or even at least three times or at least five times of each thickness d3 of each individual one of the electrically conductive layer structures 106. What concerns layer structures 112, 114, this ensures high electric and thermal performance of component carrier 100. What concerns layer structures 106, this leads to a compact design of component carrier 100 in vertical direction. For example, each of layer structure 112, 114 may be embodied as a planar patterned metal layer or metal sheet or metal foil covering for example at least 70% of the opposing main surfaces of central portion 104. In particular, a thickness d1, d2 of each of the layer structures 112, 114 may be not more than 45%, in particular not more than 30%, of the entire thickness of the stack 102. Moreover, a thickness d1, d2 of each of the layer structures 112, 114 may be more than 5%, in particular more than 20%, of the entire thickness of the stack 102. Due to their patterning, each of the first layer structure 112 and the second layer structure 114 comprises plural sub-structures separated from each other.

As shown, each of the electronic components 110 is electrically connected to the first layer structure 112 and the second layer structure 114. More specifically, each electronic component 110 is electrically connected to a respective sub-structure of the first layer structure 112 and of the second layer structure 114. Corresponding sub-structures of the first layer structure 112 and the second layer structure 114 being electrically connected to a respective one of the electronic components 110 can be configured as a direct current port.

By respective thermally and electrically conductive connecting layers 118-120 which may comprise or consist of an electrically conductive paste (such as a sinter paste), the electronic components 110 are electrically and thermally connected with the first layer structure 112 and the second layer structure 114. Electrically conductive connecting layers 118-120 may provide sinter paste for connecting copper foils with each other and for connecting components 110 with copper foils. Establishing a connection by sintering may be preferred, in particular sinter lamination may be a simple and advantageous option. More specifically, each of conductive connecting layers 118 is directly connected to a bottom main surface of an assigned one of the electronic components 110. Furthermore, each of conductive connecting layers 119 is directly connected to a top main surface of the first layer structure 112. At the same time, each of conductive connection layers 119 is arranged at a bottom main surface of the central portion 104 and is connected via electrically conductive layer structure 106 with a respective conductive connection layer 118. Thus, said electrically conductive layer structure 106 of the stack 102 separates said conductive connecting layers 118, 119 from each other. Beyond this, each of conductive connecting layers 120 is directly connected to a bottom main surface of the second layer structure 114. Apart from this, each of conductive connection layers 120 is arranged at a top main surface of the central portion 104 and is connected via electrically conductive layer structure 106 with a respective electronic component 110. Hence, each electronic component 110 is electrically connected at its bottom main surface with conductive connection layer 118 and via electrically conductive layer structure 106 and conductive connection layer 119 with the first layer structure 112. Moreover, each electronic component 110 is electrically connected at its top main surface through vertical connections 128 and electrically conductive layer structure 106 with conductive connection layer 120 and via conductive connection layer 120 to the second layer structure 114.

Vertical connections 128 may be metal-filled vias, such as copper-filled laser vias. Moreover, vertical through connections 150 located laterally between the electronic components 110 connect electrically conductive layer structures 106 above and beneath the electronic components 110 with each other. In particular, said vertical through connections 150 may be embodied as mechanically drilled vertical holes filled with metallic material (in particular copper-filled mechanical vias). Alternatively, said vertical through connections 150 may be also metal pillars, such as copper pillars. As shown, a top surface of a first of said components 110 is electrically connected to a bottom surface of a second of said components 110 by vertical through connections 150 extending through the central portion 104 in between the electronic components 110, 110.

The mentioned connections are realized so that the two electronic components 110 embedded in the central portion 104 are connected with each other by interconnected electrically conductive layer structures 106, conductive connection layer 118, vertical connections 128 and vertical through connections 150. In this way, a conductive area 124 at a top main surface of one of said electronic components 110 (the left one according to Figure 1) is electrically coupled with a further conductive area 125 at a bottom main surface of the other electronic component 110 (the right one according to Figure 1). When the electronic components 110 are embodied as field effect transistor chips, said conductive area 124 may be a source pad, whereas said further conductive area 125 may be a drain pad. Moreover, a conductive area 123 of one of the electronic components 110 (the left one according to Figure 1) may be electrically coupled via electrically conductive layer structures 106 and vertical connections 128 with a vertical through connection 130 (described below in further detail) up to an upper main surface of the component carrier 100. Said conductive area 123 may be a gate pad. Further conductive area 125 of said electronic component 110 (the left one according to Figure 1) may be coupled through conductive connection layers 118, 119 and an electrically conductive layer structure 106 in between to a section of said first layer structure 112. The latter mentioned conductive area 125 may be a drain pad of said electronic component 110. Furthermore, a conductive area 124 of the other electronic component 110 (the right one according to Figure 1) may be electrically coupled via an electrically conductive layer structure 106 and vertical connections 128 as well as via conductive connecting layer 120 with a section of the second layer structure 114 up to an upper main surface of the component carrier 100. Said conductive area 124 may be a source pad. Further conductive area 125 of said electronic component 110 (the right one according to Figure 1) may be coupled through conductive connection layers 118, 119 and an electrically conductive layer structure 106 in between to another section of said first layer structure 112. The latter mentioned conductive area 125 may be a drain pad of said electronic component 110. Hence, each of the electronic components 110 has two opposing main surfaces, one main surface comprising two conductive areas 123, 124, and the other main surface comprising further conductive area 125. For both electronic components 110, further conductive area 125 is on the bottom main surface. The electronic components 110 may be vertical devices, i.e. semiconductor dies experiencing a vertical current flow during operation. The electronic components 110 may be MOSFETs dies. One or more optional further electronic components, such as a driver chip, are not illustrated.

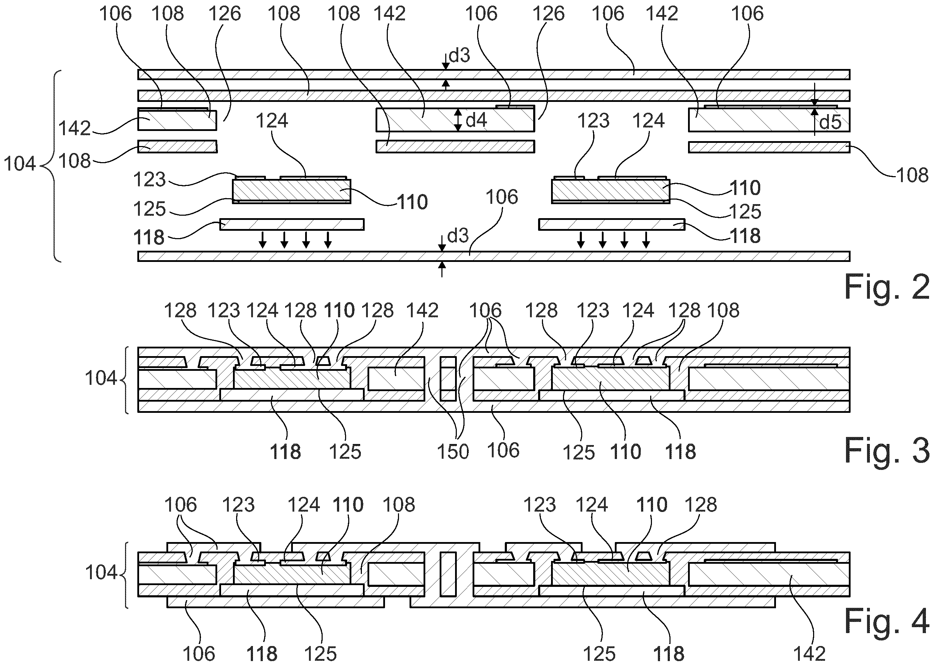

The electrically insulating layer structures 108 of the central portion 104 of the stack 102 comprise a central core 142. Said core 142 may be made of inorganic material, for example glass or ceramics, or a cured organic material, for example of FR4 material, and may be the thickest among the electrically insulating layer structures 108. Cavities (see reference signs 126 in Figure 2) may be formed in said core 142, wherein each electronic component 110 is embedded in a respective cavity 126. On or above both opposing main surfaces of core 142, one or more electrically conductive layer structures 106 and one or more electrically insulating layer structures 108 may be provided. According to Figure 1, one electrically conductive layer structure 106 is formed as a patterned metal layer directly on the top main surface of core 142. This patterned metal layer is electrically connected to conductive areas 123, 123 of the electronic components 110, 110.

Already mentioned vertical through connection 130 passes vertically through the entire central portion 104 of stack 102 as well as through the entire layer structures 112, 114. Vertical through connection 130 establishes an electric connection via a through hole formed through the thick copper foils and central portion 104. Vertical through connections 130 may comprise an electrically conductive sleeve filled with an electrically insulating filling medium 160. Said vertical through connection 130 is electrically coupled with electrically conductive area 123 of one of the electronic components 110 (according to Figure 1, electronic component 110 on the left-hand side). Said electric coupling is accomplished by electrically conductive layer structures 106 and vertical connections 128 of central portion 104. The vertical through connection 130 may form a signal port for providing a control signal to electrically conductive area 123 (which may be a gate pad) of said electronic component 110. The vertical through connection 130 is electrically insulated with respect to the first layer structure 112 and the second layer structure 114 by electrically insulating blocks forming an electrically insulating clearance structure 134 arranged above and below the central portion 104 laterally from the first layer structure 112 and the second layer structure 114. Preferably, the clearance structure 134 comprises an electrically insulating and thermally conductive material, for instance a thermal prepreg or a ceramic. The vertical through connection 130 is formed to extend vertically through said electrically insulating clearance structure 134. As shown, the vertical through connection 130 passes through the electrically insulating clearance structure 134. Moreover, electrically insulating clearance structure 134 separates sub-structures of the first layer structure 112 and separates sub-structures of the second layer structure 114. Said sub-structures of the first layer structure 112 and the second layer structure 114 are separated by the electrically insulating clearance structure 134 so that a resulting electric path involving vertical through connection 130 is exclusively for signal routing. Via one or more vertical through connections 130 passing through electrically insulating clearance structure 134 one or both of the conductive areas 123 which may be embodied as gate pads may be supplied with control signals. As shown, the clearance structure 134 extends vertically through the entire first layer structure 112 and through the entire second layer structure 114 for completely separating sub-structures of the first layer structure 112 and of the second layer structure 114.

The vertical through connection 130 described before is located on the left-hand side of component carrier 100. As can be taken from Figure 1, one or more further vertical through connections 130 may be provided as well, for instance the ones shown on the right-hand side of Figure 1. With regard to its or their construction, reference is made to the above description of the first mentioned vertical through connection 130.

Moreover, Figure 1 shows that a trench 162 (or a further cavity) can be formed in an upper main surface of the stack 102. For instance, said trench 162 may extend up to or into the central portion 104. An external component 110' can be inserted or arranged in trench 162. External component 110' may be a surface mounted device. For example, said external component 110' may be a temperature sensor such as an NTC (negative temperature coefficient) sensor. It may also be possible that said external component 110' is arranged partially or entirely in the clearance structure 134 (not shown in Figure 1).

Preferably, a volume percentage between the first layer structure 112 and its assigned portion of the clearance structure 134 is higher than a volume percentage of the electrically conductive layer structures 106 of the central portion 104 and the electrically insulating layer structures 108 of the central portion 104. Correspondingly, a volume percentage between the second layer structure 114 and its assigned portion of the clearance structure 134 is higher than a volume percentage of the electrically conductive layer structures 106 of the central portion 104 and the electrically insulating layer structures 108 of the central portion 104. In other words, a percentage of metal may be smaller in the central portion 104 of stack 102 compared with both peripheral portions of stack 102, wherein one of said peripheral portions is defined by first layer structure 112 and the portion of the clearance structure 134 therein, and the other of said peripheral portions is defined by second layer structure 114 and the portion of the clearance structure 134 therein. Hence, the peripheral portions may contribute significantly both to current carrying capability as well as heat removal of component carrier 100. Further preferably, a volume percentage between the first layer structure 112 and a sum of the first layer structure 112 and its assigned portion of the clearance structure 134 may be at least 80%, for instance at least 90%. Accordingly, a volume percentage between the second layer structure 114 and a sum of the second layer structure 114 and its assigned portion of the clearance structure 134 may be at least 80%, for instance at least 90%. Thus, the vast majority of the peripheral portions may be metallic, leading to a high current carrying capability and therefore to a full compliance with power applications. Moreover, the high metallic contents in the peripheral portions of the component carrier 100 may also promote heat removal.

As shown as well in Figure 1, the stack 102 comprises a surface protection layer 138 forming part of an upper exterior main surface of component carrier 100. The surface protection layer 138 is a patterned solder resist formed partially on the uppermost electrically conductive layer structure 106 and the uppermost electrically insulating layer structure 108 of the stack 102. The surface protection layer 138 embodied as solder resist protects specific surface portions of component carrier 100 against coverage with solder to be applied on exposed portions of the uppermost electrically conductive layer structure 106 only. Furthermore, the solder resist also protects underlying portions against oxidation.

In addition, a further surface protection layer 138' is provided also on lateral sides of the stack 102. Further surface protection layer 138' may also be a dielectric and may provide an electrically insulating protection to the sidewalls of the component carrier 100. This may be advantageous in particular for high power applications. Further surface protection layer 138' may form part of electrically insulating clearance structure 134, which may simplify the manufacturing process.

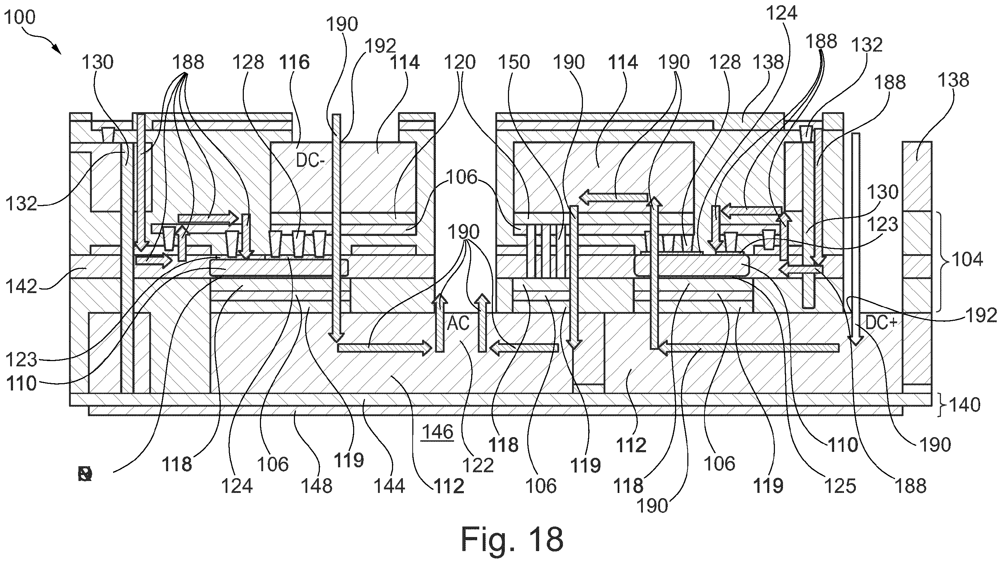

An outermost structure 140 of the stack 102 on its bottom side may comprise a thermally conductive and electrically insulating layer 144, in particular a ceramic layer or a layer of thermal prepreg. As shown, the thermally conductive and electrically insulating layer 144 is covered by a metal layer 148 which also forms part of the outermost structure 140. Thus, an exterior surface of the outermost structure 140 may be constituted by the metal layer 148 (for example a copper foil) which may be configured to be coupled with a heat sink, a chassis or the like (indicated schematically with reference sign 146 in Figure 18 and shown in Figure 23). Alternatively, the outermost structure 140 may have a fragmental surface, for example comprising a heat sink and a planar surface, a further component, etc. (not shown). The outermost structure 140 may comprise a layer of surface finish to prevent oxidation.

In the following, electric interconnections of component carrier 100 will be described in further detail: Figure 1 illustrates a gate access 168 (for example of low-side (LS) transistor die), a source access top layer 170, a source access 171 (for example of high-side (HS) transistor die) in a further cavity 172, a source access 173 (for example of low-side (LS) transistor die) in yet another cavity 174, and a gate access 176 (for example of a high-side (HS) transistor die). Gate access 176 may be connected to the gate pad in form of conductive area 123 of the electronic component 110 on the right-hand side of Figure 1, as it is shown for the other electronic component 110 on the left-hand side of Figure 1. Concerning gate access 176, it is possible that a further electrically conductive layer structure 106 is arranged on top of electrically and thermally conductive second layer structure 114 to form connection pads for the gate contact. Although this further electrically conductive layer structure 106 is optional, it may be advantageous, because otherwise connection of vertical through connection 130 might be challenging. With regard to the electric functionality of component carriers 100 according to exemplary embodiments, reference is made to Figure 18 and corresponding description.

In a nutshell, the embodiment of Figure 1 provides a component carrier 100 having two copper foils in form of first layer structure 112 and second layer structure 114 on both sides of stack 102 with embedded components 110 therein. Advantageously, the manufacture of component carrier 100 according to Figure 1 does not need to provide copper inlays, it may be sufficient to simply laminate the copper foils to both opposing main surfaces of the central portion 104 of the stack 102. This may allow to flexibly select copper foils for a specific application, for instance in terms of thickness selection. Fast and efficient manufacture of component carrier 100 is possible. In particular, the thicknesses d1, d2 of the first layer structure 112 and the second layer structure 114 may define the maximum current carrying capability, so that low power, medium power and high power applications may be supported by the component carrier construction and manufacturing architecture according to Figure 1. Furthermore, the overall thickness of component carrier 100 may be small. There is a high freedom to play with copper foil thicknesses to meet a current requirement of a specific application. Thus, an embedded components concept may be combined with a sandwiching, from both sides, of processed copper foils. As embedded components 110, it may for instance be possible to provide silicon carbide chips (for providing high performance, high current and fast switching) or gallium nitride chips (in particular for fast switching).

The general concept of exemplary embodiments of the invention may be the arrangement of a central portion 104 between two opposing thick copper layers as first layer structure 112 and second layer structure 114. Advantageously, the construction of the central portion 104 is flexible. One or more electronic components 110 are embedded in said central portion 104 according to any desired embedding technology. Moreover, exemplary embodiments allow a simple manufacture, since registration may be easier. A larger tolerance is allowed compared to conventional approaches, since no alignment of different cores to each other is necessary in exemplary embodiments.

For example, some or all of the conductive connection layers 118-120 may have the same size with respect to each other (see reference signs 118 and 119 in contact with the electronic component 110 on the left-hand side). Additionally or alternatively, some or all of the conductive connection layers 118-120 may have different sizes with respect to each other (see reference signs 118, 119 in contact with the electronic component 110 on the right-hand side). Furthermore, the conductive connection layers 118-120 may have different size in comparison to the adjacent layer structure 112, 114 and/or the electronic components 110.

Figure 2 to Figure 11 illustrate cross-sectional views of structures obtained during carrying out a method of manufacturing a component carrier 100, shown in Figure 1, according to an exemplary embodiment of the invention.

Referring to **Figure 2****,** an arrangement of still separate electrically conductive layer structures 106 and electrically insulating layer structures 108 are shown. The electrically conductive layer structures 106 may be copper foils (on top and on bottom) having a thickness d3 (which may be the same or different for different electrically conductive layer structures 106). For instance, thickness d3 may be in a range from 2 µm to 70 µm. A continuous and a patterned electrically insulating layer structure 108 made of an at least partially uncured material such as prepreg are shown. Furthermore, a patterned core 142, which may be made of FR4 material, is shown having a thickness d4. For instance, thickness d4 may be in a range from 50 µm to 400 µm, preferably in a range from 75 µm to 300 µm. On a top main surface of core 142, a patterned electrically conductive layer structure 106 is shown having a thickness d5. For instance, thickness d5 may be in a range from 18 µm to 35 µm. Together, the patterned electrically insulating layer structure 108 and the patterned core 142 may define cavities 126 for accommodating a respective electronic component 110. The electronic components 110 may for instance be embodied as MOSFETs, and may be for instance manufactured in silicon technology, silicon carbide technology, lateral gallium nitride technology or vertical gallium nitride technology. By the electrically conductive connecting layers 118, which may be sheet structures of sinter paste, a connection between the lowermost electrically conductive layer structure 106 and the electronic components 110 may be accomplished. Figure 2 shows the process of chip on foil sinter lamination. Preferably, the two electronic components 110 may have the same lateral size and/or size in thickness direction one to each other. Alternatively, the two electronic components 110 may have different lateral size and/or size in thickness direction compared one to each other.

Referring to **Figure 3****,** the constituents of Figure 2 are shown interconnected after sinter lamination. Sinter lamination may include one or a plurality of lamination steps. Furthermore, an obtained structure may be subjected to drilling and plating. Drilling may form laser vias and/or mechanical vias in the obtained structure. Plating (for instance involving electroless plating for forming a seed layer and thereafter electroplating, for instance galvanic plating) may then be carried out for filling the laser-drilled and mechanically-drilled holes with metallic material such as copper. As a result, vertical connections 128 (in particular copper-filled laser vias) as well as vertical through connections 150 (in particular metal-filled mechanically drilled vias, or copper pillars) may be obtained. Thus, a central portion 104 of a stack 102 (see for instance Figure 1) under manufacture is created. For example, the electrical connection to source pad in form of conductive area 124 and gate pad in form of conductive area 123 may be created by the vertical interconnections 128, whereas the electrical connection of the drain pad in form of further conductive area 125 may be created by the conductive connection layer 118.

Referring to **Figure 4****,** the illustrated structure is obtained by patterning the exposed electrically conductive layer structures 106 on both opposing main surfaces of the structure of Figure 3.

Referring to **Figure 5****,** a bottom-sided first layer structure 112 with top-sided patterned conductive connection layer 119 is provided. The first layer structure 112 may be embodied as a thick copper foil. Patterned conductive connection layer 119 may be embodied as a pattern of electrically conductive sinter paste. Although this is a preferred choice, other embodiments may rely on other connection techniques, for instance involving electrically conductive glue and/or solder material. Furthermore, a top-sided second layer structure 114 with bottom-sided patterned conductive connection layer 120 is provided. The second layer structure 114 may be embodied as a thick copper foil. Patterned conductive connection layer 120 may be embodied as a pattern of electrically conductive sinter paste. The structure of Figure 4 is arranged between the bottom-sided first layer structure 112 and the top-sided second layer structure 114 with patterned and at least partially uncured electrically insulating layer structures 108 (such as resin sheets with optional stiffening structures like glass spheres or glass fibers) in between. The patterned electrically insulating layer structures 108 may have through openings in regions aligned with sections of the conductive connecting layers 119, 120.

Referring to a detail 178 in Figure 5, a thickness d1 of the first layer structure 112 may be larger than a thickness d2 of the second layer structure 114 (or vice versa). However, thickness d1 or first layer structure 112 and thickness d2 of second layer structure 114 may also be the same. The thicknesses d1 and d2 can be selected in particular in accordance with a required current carrying capability of the readily manufactured component carrier 100. Advantageously, each thickness d1, d2 of a respective one of the first layer structure 112 and the second layer structure 114 may be in a range from 200 µm to 800 µm. In order to keep the thickness of the readily manufactured component carrier 100 small, the thicknesses d1, d2 of the first layer structure 112 and the second layer structure 114 may be larger than the thicknesses d3, d5 of the electrically conductive layer structures 106 of the pre-stack in between.

The chip on foil arrangement according to Figure 5 is ready for subsequent sinter lamination of the thicker copper foils of first and second layer structures 112, 114 onto the pre-stack comprising core 142 with its embedded components 110. For example, sinter lamination may involve process parameters of an elevated temperature of at least 70°C and/or an elevated pressure of at least 1.5 bar. Alternative processes for establishing connections may also be carried out at room temperature, for instance nanowire connection.

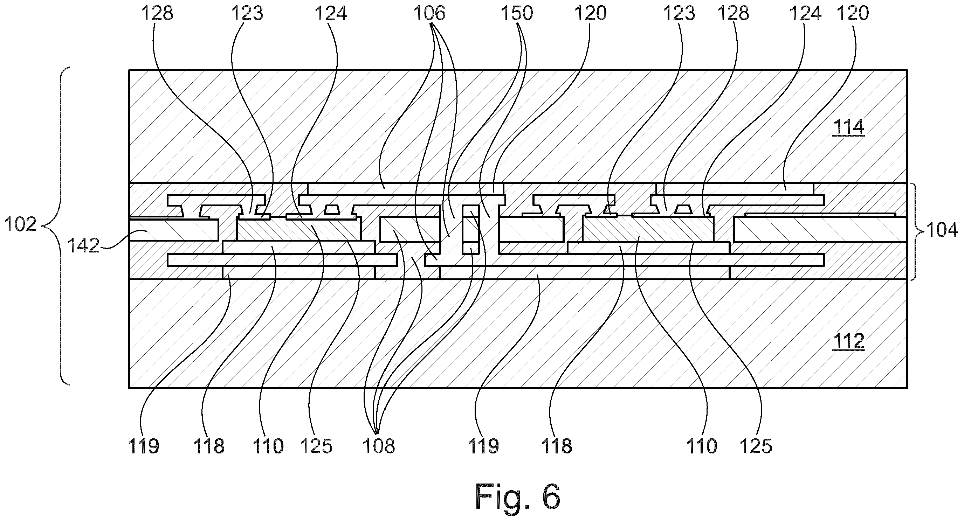

Referring to **Figure 6****,** a structure obtained after having executed sinter lamination of the constituents of Figure 5 is shown. Advantageously, sinter lamination is highly reliable also for the high power devices in form of embedded electronic component 110.

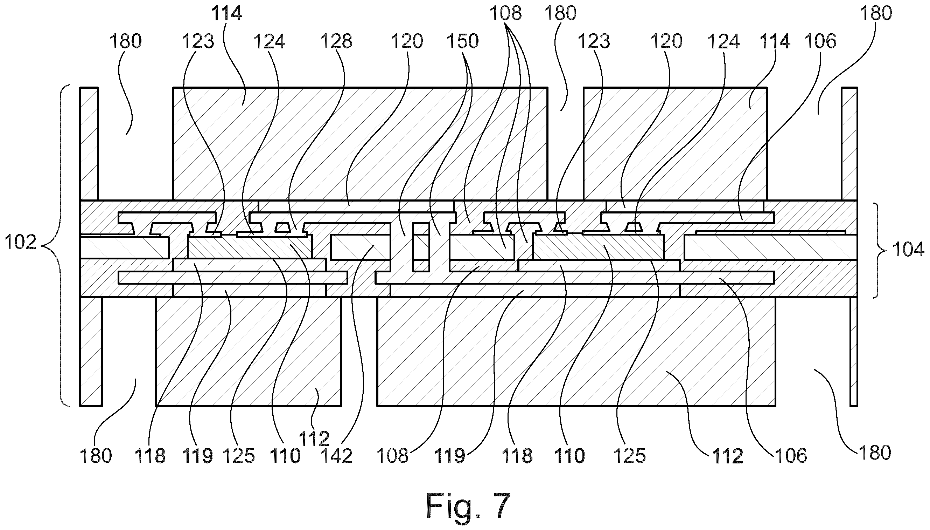

Referring to **Figure 7****,** the first layer structure 112 and the second layer structure 114, provided initially as continuous copper foils, are structured or patterned for forming trenches 180. Preferably, an etching process, in particular a wet chemical etching process, may be used to structure the first layer structure 112 and the second layer structure 114. Structuring of the first layer structure 112 and the second layer structure 114 may be done simultaneously or consecutively within two structuring steps.

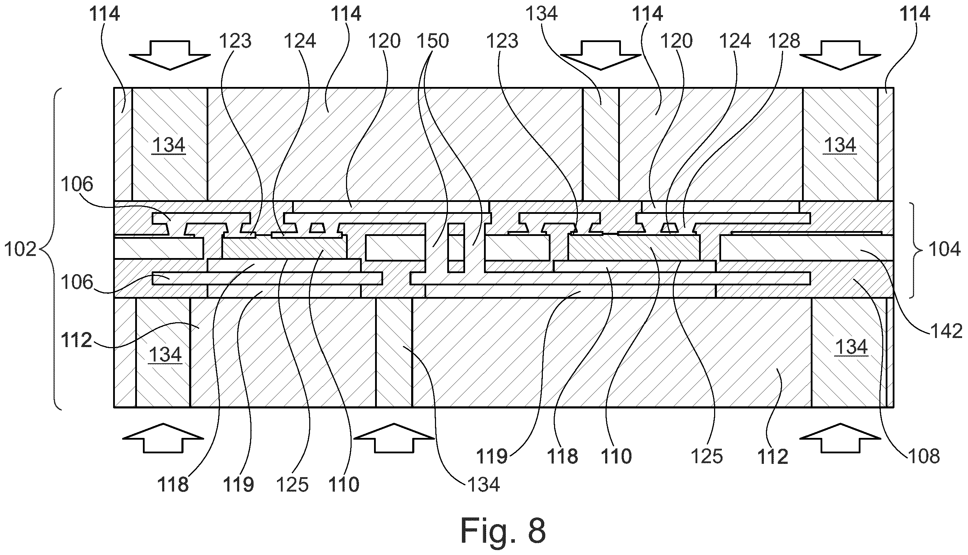

Referring to **Figure 8****,** the trenches 180 are filled with dielectric material, thereby forming electrically insulating clearance structures 134. Hence, gap filling with dielectric material is performed. Preferably, the electrically insulating clearance structure 134 may comprise a paste. This may ensure a reliable filling of the trenches 180. Preferably, the electrically insulating clearance structure 134 may be void free.

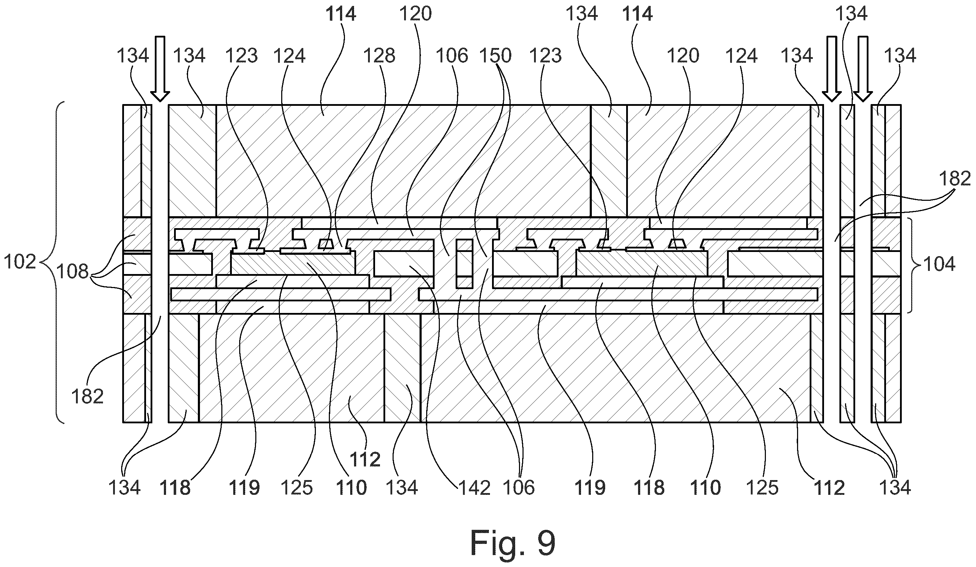

Referring to **Figure 9****,** trenches 182, which are narrower than previously formed trenches 180, are created in some of the electrically insulating clearance structures 134 and extend also through central portion 104 of stack 102. In other words, the trenches 182 may extend through the entire thickness of the stack 102 forming a through hole. This process may be carried out particularly advantageously with a thickness d1, d2 of the layer structures 112, 114 in a range from 400 µm to 800 µm. Thereby, it may be possible to mechanically drill a signal path in the dielectric material of the respective electrically insulating clearance structures 134. By taking this measure, it may be possible to create gate connections for the embedded electronic components 110. Alternatively, the trench extends through the electrically insulating clearance structure 134 and only partially into the central portion 104, for instance forming a blind hole.

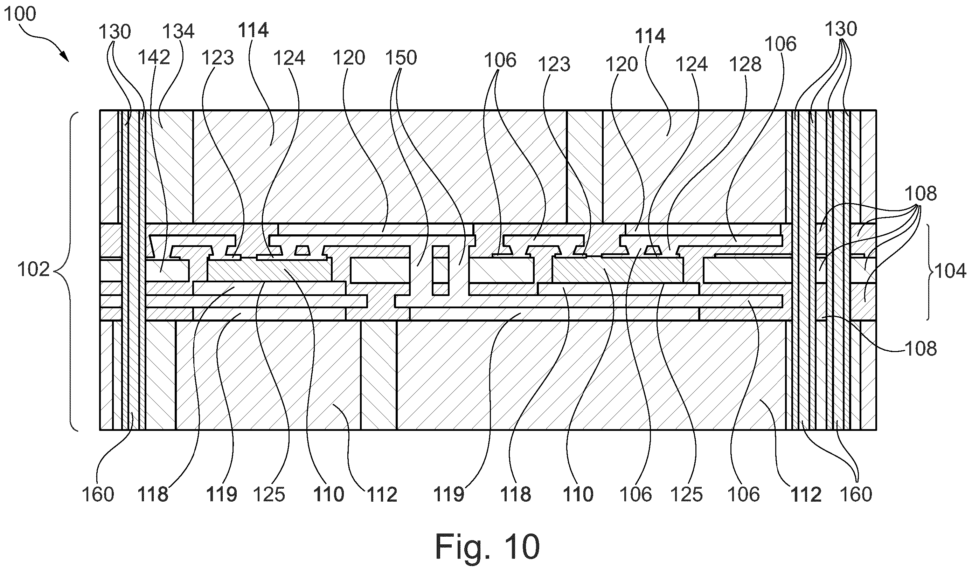

Referring to **Figure 10****,** electrically conductive vertical through connections 130 are formed in the further trenches 182. In particular, this may be accomplished by covering the sidewalls of the trenches 182 with electrically conductive material, such as copper. For instance, this may be done by electroless plating. Thereafter, remaining interior voids within the sleeve-shaped electrically conductive vertical through connections 130 may be filled partially or entirely with an electrically insulating filling medium 160 (for example plug paste). Hence, copper plating and plugging with dielectric material of drilled holes in dielectric stack material may be done for forming the signal paths, in particular for gate connections. Alternatively, the vertical through connections 130 may be completely filled with electrically conductive material such as plated metal or paste material.

Concerning thickness, central portion 104 may be composed of an upper section with a partial thickness of for instance 135 µm, a central section (embedding electronic components 110) with a partial thickness preferably in a range from 100 µm to 200 µm, and a lower section with a partial thickness of for example 135 µm. For a 100 µm thick chip, this may lead to a thickness of stack 102 in a range from 1170 µm to 1970 µm. For a 200 µm thick chip, this may lead to a thickness of stack 102 in a range from 1270 µm to 2070 µm.

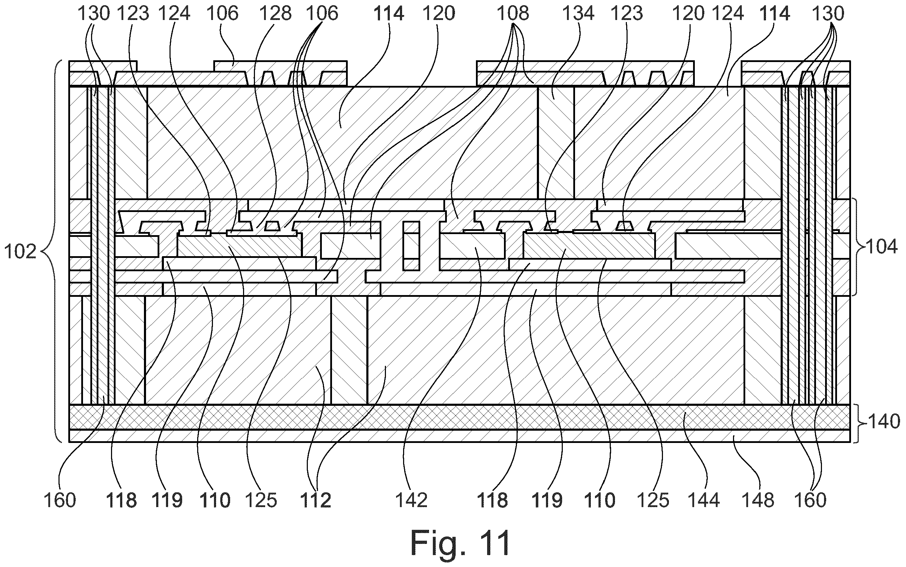

Referring to **Figure 11****,** a further build-on the top side and/or on the bottom side of the stack 102 according to Figure 10 may be formed. The build-up on the bottom side may be constituted by outermost structure 140, as described above referring to Figure 1. For example, the build-up on the bottom side may form an interface to a heat sink (not shown) of the like. The build-up on the top side may be for example at least one further patterned electrically conductive layer structure 106 and/or at least one further electrically insulating layer structure 108. For example, the build-up on the top side may form an electric interface to an electronic periphery to which the component carrier 100 may be connected.

For completing manufacture of the component carrier 100 according to Figure 1, surface protection layers 138, 138' may be formed and surface mounting of further electronic component 110' described referring to Figure 1 may be done.

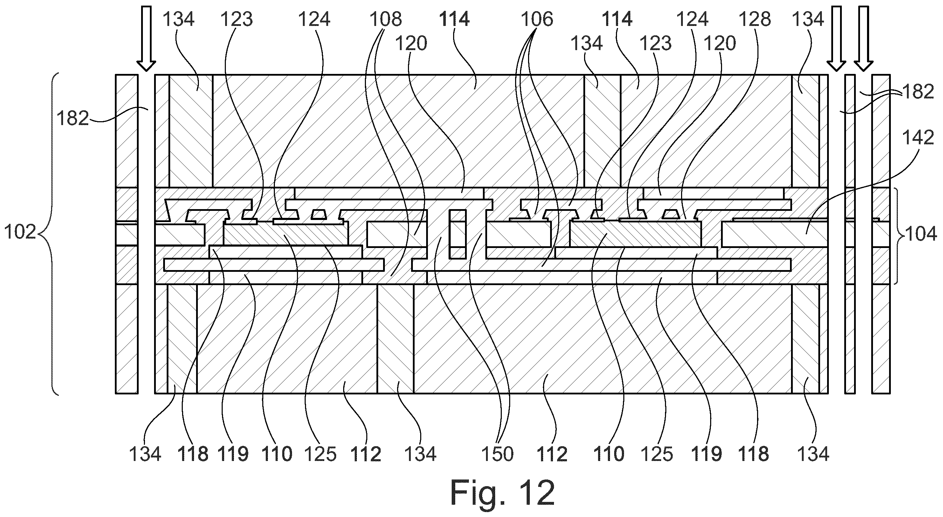

Figure 12 to Figure 15 illustrate cross-sectional views of structures obtained during carrying out a method of manufacturing a component carrier 100, shown in Figure 15, according to another exemplary embodiment of the invention. The embodiment of Figure 12 to Figure 15 differs from the embodiment of Figure 1 to Figure 11 in particular in that, according to Figure 12 to Figure 15, the thicknesses d1, d2 of the layer structures 112, 114 may be preferably lower, for instance in a range from 200 µm to 400 µm. Further characteristics and differences of the embodiment of Figure 12 to Figure 15 will be explained of the following.

The structure according to **Figure 12** differs from the structure according to Figure 9 in particular in that the trenches 182 are formed to extend directly through the first and second layer structures 112, 114, rather than the electrically insulating clearance structures 134. In other words, parts of the trenches 182 of Figure 12 are delimited by the first and second layer structures 112, 114. In order to accomplish this, the mechanical drilling process for forming the trenches 182 extends directly through the copper foils of the first and second layer structures 112, 114. Drilling may occur for creating a signal path through copper foils (in particular for forming gate connections).

Concerning thickness, central portion 104 may be composed of an upper section with a partial thickness of for instance 135 µm, a central section (embedding electronic components 110) with a partial thickness preferably in a range from 100 µm to 200 µm, and a lower section with a partial thickness of for example 135 µm. For a 100 µm thick chip, this may lead to a thickness of stack 102 in a range from 770 µm to 1170 µm. For a 200 µm thick chip, this may lead to a thickness of stack 102 in a range from 870 µm to 1270 µm.

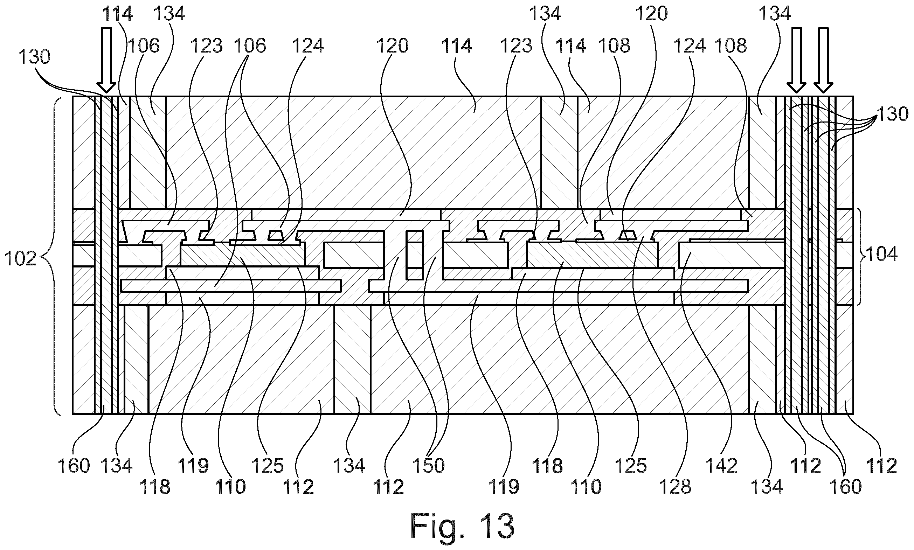

Referring to **Figure 13****,** copper plating and plugging of drilled holes for creating the signal path (in particular for creating gate connections) may be carried out, as described above referring to Figure 10.

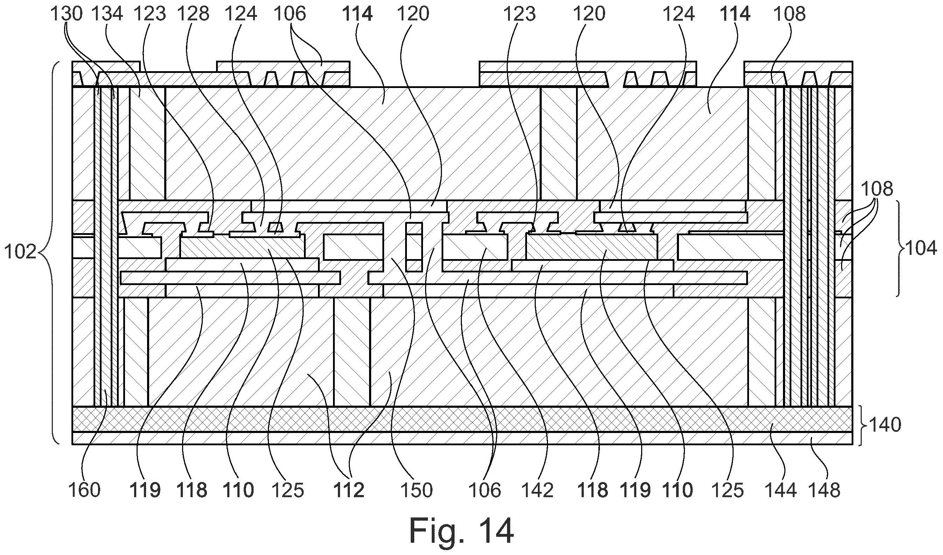

Referring to **Figure 14****,** formation of a top and bottom build-up on the opposing main surfaces of the structure shown in Figure 13 may be carried out, as described above referring to Figure 11.

Referring to **Figure 15****,** formation of surface protection layers 138, 138' and surface mounting of further electronic component 110' may be carried out, as described above referring to Figure 1.

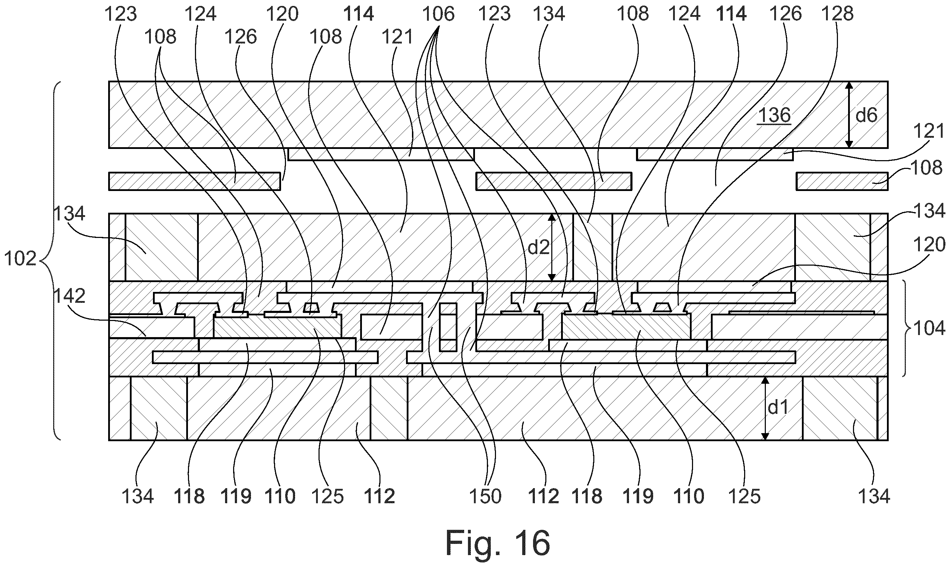

**Figure 16** and **Figure 17** illustrate cross-sectional views of structures obtained during carrying out a method of manufacturing a component carrier 100, shown in Figure 17, according to another exemplary embodiment of the invention. The embodiment of Figure 16 and Figure 17 differs from the embodiment of Figure 1 to Figure 11 in particular in that, according to Figure 16 and Figure 17, three (rather than two) thick copper layers may be provided, in particular for high current applications. Alternatively, component carriers 100 according to exemplary embodiments may be used in ships, airplanes, railways, cars, or in energy plants, for example wind energy plants. The thicknesses d1, d2 of the layer structures 112, 114 may be preferably in a range from 200 µm to 800 µm. For an additional third layer structure 136 to be arranged on top of second layer structure 114, a thickness d6 may be preferably in a range from 200 µm to 800 µm. Although two electronic components 110 are shown in Figure 17, it may be possible to provide at least one further electronic component 110 (not shown) for providing an electronic application with at least three levels (or even six electronic component 110, for instance for a sixpack configuration). Further characteristics and differences of the embodiment of Figure 16 and Figure 17 will be explained of the following.

As already mentioned, the component carrier 100 according to Figure 16 and Figure 17 comprises an electrically and thermally conductive third layer structure 136 on top of the second layer structure 114. The third layer structure 136 is connected with said second layer structure 114 by a patterned conductive connecting layer 121, in particular comprising a conductive sinter paste. Furthermore, an additional electrically insulating layer structure 108 (for instance a pattern prepreg layer) is sandwiched between the second layer structure 114 and the third layer structure 136, wherein through holes or cavities 126 of the additional electrically insulating layer structure 108 are aligned with sections of the conductive connection layer 121. Based on the aligned constituents of Figure 16, sinter lamination may be carried out for obtaining component carrier 100 according to Figure 17. After said sinter lamination, processes such as those described above referring to Figure 9 to Figure 11 and Figure 1 may be carried out for obtaining component carrier 100 with features of Figure 17.

As can be taken from Figure 17, a section of the third layer structure 136 is electrically connected to conductive area 124 of the electronic component 110 shown on the left-hand side and to conductive area 125 of the electronic component 110 shown on the right-hand side. Another section of the third layer structure 136 (separated by the aforementioned section by an electrically insulating clearance structure 134 in the third layer structure 136) is electrically connected to conductive area 124 of the other electronic component 110 shown on the right-hand side. For example, the third layer structure 136 may be a patterned plated metal layer or metal foil, alternatively it may be an inlay. In the latter case, a surrounding of an inlay-type third layer structure 136 may have an appearance as shown in a detail 197 in Figure 17. Moreover, the third layer structure 136 is electrically coupled with sub-sections of both the first layer structure 112 and the second layer structure 114. Another sub-section of the first layer structure 112 beneath the electronic component 110 on the left-hand side of Figure 17 is electrically decoupled from the third layer structure 136.

In the following, electric interconnections of component carrier 100 of Figure 17 will be described. For instance, three electric levels (high, low and middle) may be supported. Figure 17 illustrates a gate access 168 (for example of low-side (LS) transistor die), a source access top layer 170, a source access 171 (for example of high-side (HS) transistor die) in a further cavity 172, a source access 173 (for example of low-side (LS) transistor die) in yet another cavity 174, and a gate access 186 (for example of a middle level (M-path) transistor die).

The third layer structure 136 may be differently structured than the adjacent second layer structure 114. This may be due to heat guiding reasons. Alternatively, the structuring of layer structures 114, 136 may be the same.

**Figure 18** illustrates a cross-sectional view of a component carrier 100 according to another exemplary embodiment of the invention. Figure 18 shows signal paths 188 for supplying control signals and current paths 190 for supplying electric current during operation of the component carrier 100.

Starting with the signal paths 188, a first vertical through connection 130 (shown on the left-hand side of Figure 18) forms a signal port 132 for providing a control signal to conductive area 123 (in particular a gate pad) of the first electronic component 110 (shown on the left-hand side of Figure 18). Still referring to the signal paths 188, a second vertical through connection 130 (shown on the right-hand side of Figure 18) forms a further signal port 132 for providing a control signal to conductive area 123 (in particular a gate pad) of the second electronic component 110 (shown on the right-hand side of Figure 18). As can be taken from the signal paths 188 in Figure 18, control signals are supplied to the conductive areas 123 (gate pads) of the electronic components 110 through sections of the second layer structure 114. The portion of the signal path 188 on the left-hand side of Figure 18 relates to a gate loop for providing a signal path for the low-side chip. The portion of the signal path 188 on the right-hand side of Figure 18 relates to a gate loop for providing a signal path for the high side chip.

Now referring to the current paths 190, each of the first layer structure 112 ("DC+") and the second layer structure 114 ("DC-") is configured to provide a respective direct current port 192. Still referring to the current paths 190, the first layer structure 112 is further configured to provide an alternating current port 122 ("AC"). During operation of the component carrier 100, the first layer structure 112 being directly connected, through conductive connection layers 118, 119 and an electrically conductive layer structure 106 in between, to the conductive areas 125 (drain pads) on the bottom main surface of the electronic components 110 is configured for providing only a power function. In the shown embodiment, the first layer structure 112 does not contribute to signal supply. The second layer structure 114 contributes to signal supply (as described above), but has also sections in the current paths 190, thereby contributing to current supply as well. Thus, both the first layer structure 112 and the second layer structure 114 are configured for providing a power function during operation of the component carrier 100. The portion of the current path 190 on the left-hand side of Figure 18 relates to a current flow DC- to AC on the low-side. The portion of the current path 190 on the right-hand side of Figure 18 relates to a current flow DC+ to AC on the highside.

Figure 19 to Figure 22 illustrate cross-sectional images of structures obtained during carrying out a method of manufacturing a component carrier 100 according to another exemplary embodiment of the invention.

Referring to **Figure 19****,** a portion of the second layer structure 114 is illustrated (the first layer structure 112 and/or the third layer structure 136 may be configured correspondingly). As shown in Figure 19, the illustrated second layer structure 114 is formed by a patterned conductive layer provided on one side of the central portion 104. Said patterned conductive layer comprises lateral walls having a concave shape with a vertically intermediate enlargement feature 154 between two vertical extremities 156, 158. More specifically, the patterned conductive layer comprises lateral walls with a first slanted portion 194 from vertical extremity 158 to intermediate enlargement feature 154 slanted towards the central portion 104 of the stack 102. Moreover, the lateral wall of the patterned conductive layer comprises a second slanted portion 196 slanted from vertical extremity 156 to intermediate enlargement feature 154 facing away from the central portion 104 of the stack 102. As shown, an extension of the first slanted portion 194 is significantly greater than that of the second slanted portion 196. For instance, a length of first slanted portion 194 may be at least three times of a length of second slanted portion 196.

As can be taken from Figure 19 as well, the patterned conductive layer forming second layer structure 114 comprises lateral walls in accordance with the condition d≥T/4. In this equation, d is a horizontal offset of one extremity 158 of the patterned conductive layer on the central portion 104 of the stack 102 with respect to the opposed extremity 156 facing away from the central portion 104, and T is a thickness of the patterned conductive layer or second layer structure 114.

For example, the geometry according to Figure 19 may be obtained by etching or a combination of routing and etching.

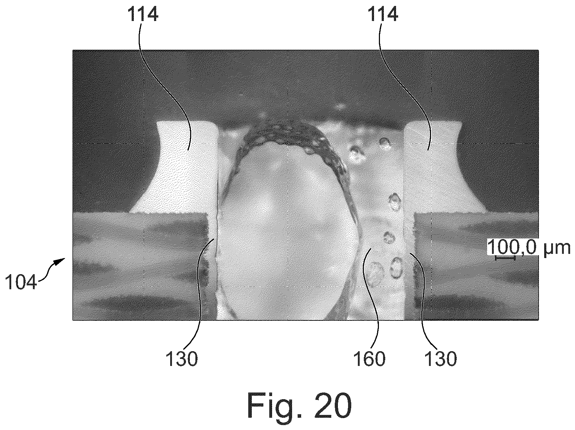

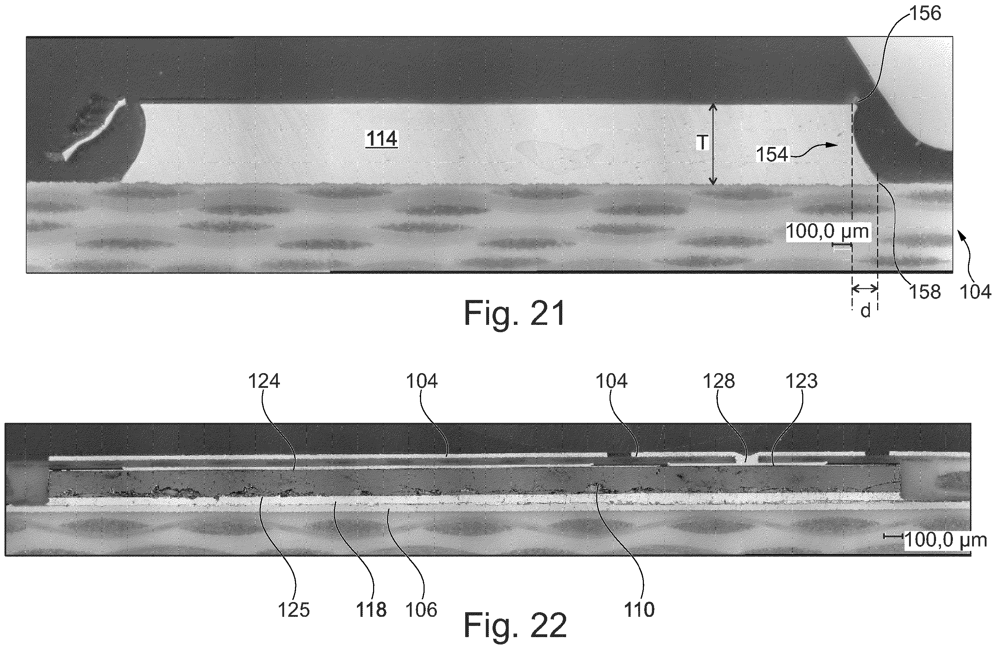

**Figure 20** shows a further cross-sectional view showing second layer structure 114 and a connected central portion 104 as well as part of a vertical through connection 130. **Figure 21** is still another illustration of a cross-section of second layer structure 114.

Referring to **Figure 22****,** a cross-sectional view of part of a component carrier 100 is shown. More specifically, Figure 22 shows electronic component 110 sintered on a copper layer. In the shown embodiment, the electronic component 110 is a silicon carbide die. The copper layer on which electronic component 110 is sintered has a thickness of 35 µm in the shown example.

**Figure 23** illustrates a cross-sectional view of a component carrier 100 according to another exemplary embodiment of the invention.

In the embodiment of Figure 23, two parallel extending vertical through connections 130 pass vertically through electrically insulating clearance structure 134 in the second layer structure 114 for vertically electrically connecting electrically conductive areas 123, 124 of the embedded electronic component 110. More specifically, the purely vertically connected electrically conductive areas 123, 124 of the electronic component 110 comprise a gate pad in form of conductive area 123 and a source pad in form of conductive area 124. The two vertical through connections 130 extend in parallel to each other along a vertical direction over the same vertical range. In a highly symmetric way, said vertical through connections 130 connect along a purely vertical path the two electrically conductive areas 123, 124 arranged side-by-side on the same main surface of the same electronic component 110. Each of the vertical through connections 130 may be composed of a plurality of vertically connected sections, for instance including a metallic via (see reference sign 128), a solder structure 212, etc. By the illustration in which the vertical through connections 130 pass entirely vertically from an uppermost electrically conductive layer structure 106 of the stack 102 up to the electrically conductive areas 123, 124 a very short connection path may be obtained. This may lead to low loss, low heating and proper signal quality.

Moreover, the vertical interconnection may be directly connected to the gate- and source- pad, both located on top of the electronic component 110. Furthermore, there can be only one vertical connection in case the layer structure 114 is used for the second electrical connection.

Advantageously, the embodiment of Figure 23 makes it possible to connect in particular the gate pad of the MOSFET-type electronic component 110 through a coaxial interconnection. The shown architecture may lead to a reduction of parasitic effects, resulting in an increase of a gate drive loop, for instance of up to 70%. Moreover, such an architecture may ensure a highly efficient signal routing for power modules. Also in terms of thermal management of power modules, the illustrated architecture is highly advantageous due to the short signal paths and therefore small ohmic losses. The architecture of component carrier 100 according to Figure 23 can more generally be used advantageously for each application comprising an implemented thermal structure, where a signal path should be shortened. For instance, such thermal structures can be copper inlays having such vertical interconnection implemented before their integration into a PCB. For instance, it is possible to provide pre-manufactured thermal inlays comprising vertical interconnections.

Further, some specific properties of the component carrier 100 according to Figure 23 will be mentioned: As shown, two surface mounted components 110' are arranged on top of the component carrier 100. Said surface mounted components 110' may be soldered using a solder structure 204 on top the stack 102. For instance, a surface finish 206 (such as Ni/Ag, ENIG or ENEPIG), which may be electrically conductive, may be provided on top of stack 102 to further promote proper soldering. On the bottom side of stack 102, a heat sink 146 may be thermally connected for further enhancing heat dissipation. An optional inlay 210 (such as a magnetic inlay and/or a thermal interface material) is shown as well in a body portion of the stack 102. The inlay 210 may comprise thermally conductive and electrically insulating material, for example ceramic material. This may ensure a reliable heat transmission to the heat sink 146 without conducting the electric current to the lowermost electrically conductive layer structure 106. Furthermore, the component carrier 100 according to Figure 4 comprises a plurality of cores 142. From bottom to top, said cores may be a DBC (Direct Bonded Copper) core, an inlay core, a power core, and a thermal core. Any other core configuration is possible as well. The conductive connecting layers 118, 120 shown in Figure 23 may be for example solder tin or a sinter paste.

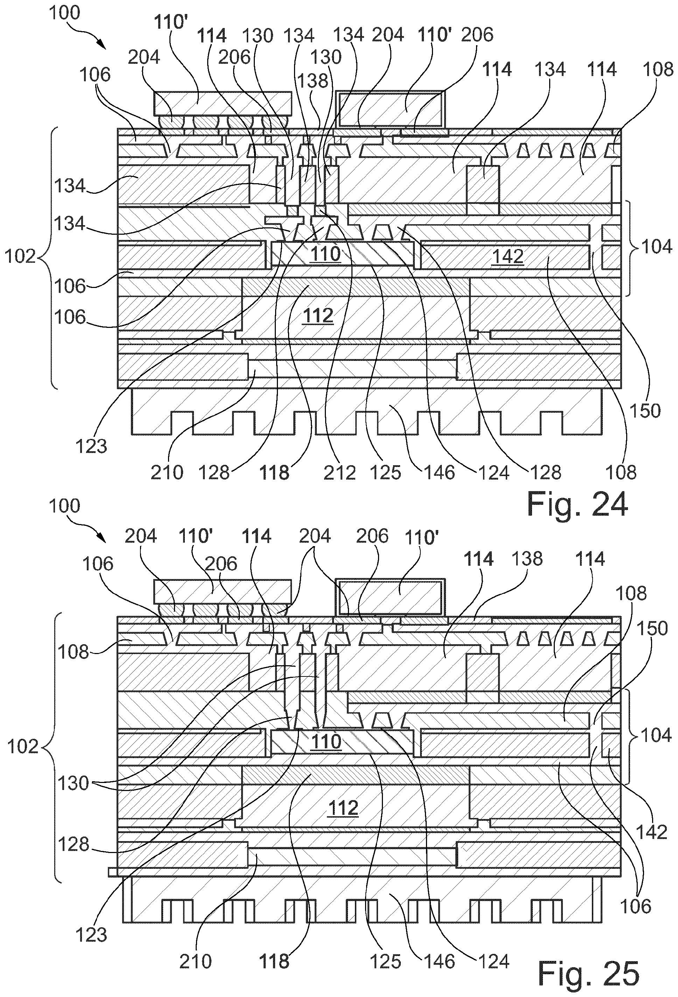

**Figure 24** illustrates a cross-sectional view of a component carrier 100 according to another exemplary embodiment of the invention. The component carrier 100 according to Figure 24 differs from the component carrier 100 according to Figure 23 in particular in that, according to Figure 24 the two vertical through connections 130 have different diameters. While the diameters of the two vertical through connections 130 may be identical as shown in Figure 23, Figure 24 shows an embodiment in which the vertical through connection 130 on the right-hand side has a larger diameter than the one of the left-hand side.

**Figure 25** illustrates a cross-sectional view of a component carrier 100 according to another exemplary embodiment of the invention. The component carrier 100 according to Figure 25 differs from the component carrier 100 according to Figure 23 in particular in that, according to Figure 25, no solder structure 212 as part of the vertical through connections 130 is foreseen. For instance, the vertical through connections 130 may be entirely made of copper. For instance, this may be realized in a two-step process to prevent a damage of the pad of the component 110. In a first step, a mechanical drilling process may be executed to open a main portion. In a second step, laser drilling may be carried out to open the last portion to the pad of the component. For example, this may lead to a straight wall (optionally with a step) and a tapered wall of the last portion to the component pads.

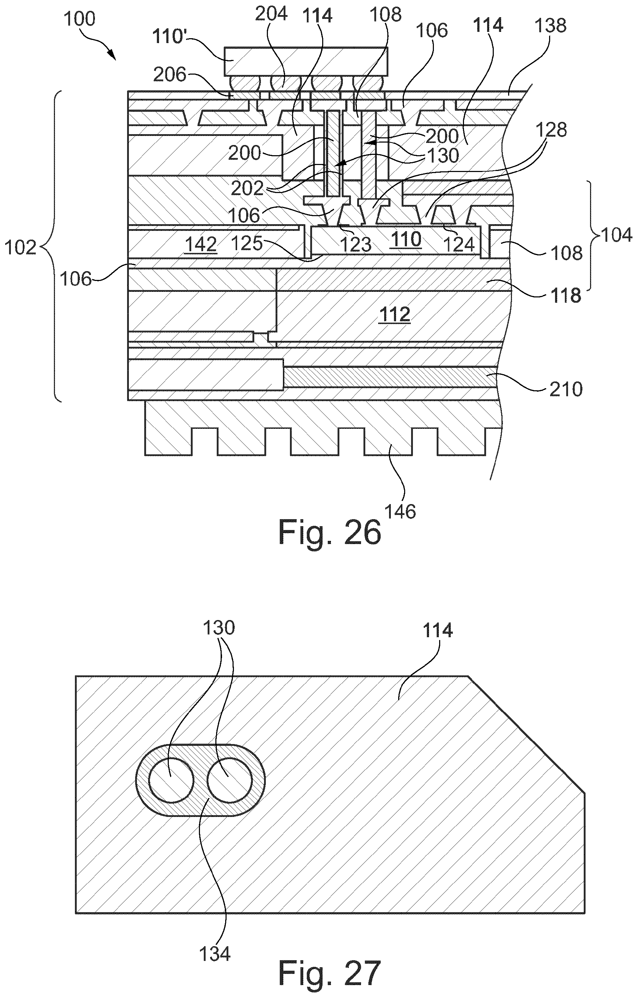

**Figure 26** illustrates a cross-sectional view of a component carrier 100 according to another exemplary embodiment of the invention. In Figure 26, the connection to the gate pad is realized by an electrically conductive layer structure 106 having the advantage to realize a pad for drilling the vertical through connection. For example, less accuracy may be needed when drilling of the vertical connection to the pad. In addition, the gate signal can be routed horizontally as well which allows more design flexibility. Figure 26 shows a plated through hole with conductive paste 200. However, this can be a resin-filled plated through hole as well. **Figure 27** illustrates a plan view of part of the component carrier 100 according to Figure 26. The component carrier 100 according to Figure 26 and Figure 27 differs from the component carrier 100 according to Figure 23 in particular in that, according to Figure 26 and Figure 27, the vertical through connections 130 are formed partially or entirely of an electrically conductive paste. The vertical through connection 130 shown on the left-hand side of Figure 26 comprises an electrically conductive sleeve 202 filled with an electrically conductive paste 200. The vertical through connection 130 shown on the right-hand side of Figure 26 comprises electrically conductive paste 200 directly surrounded by the electrically insulating clearance structure 134.

The distance between second layer structure 114 and vertical through connection 130 may be at least 500 µm, preferably at least 700 µm. Such a distance may reduce the phenomenon of arcing drastically. Moreover, the distance between second layer structure 114 and vertical through connection 130 may be larger than the distance between the respective two vertical through connections 130. In particular, the distance between the two vertical through connections 130 can be small since there may by a small potential difference provided between gate and source. In an example, the distance between the two vertical through connections 130 may be in the range from 30 µm to 400 µm.

Figure 28 to Figure 31 illustrate cross-sectional views of structures obtained during carrying out a method of manufacturing a component carrier 100 according to another exemplary embodiment of the invention.

Referring to **Figure 28****,** the electronic components 110 are to be accommodated in an accommodation volume or a cavity 126 defined between sidewalls of a patterned electrically insulating layer structure 108 (core 142 in the shown embodiment) and a main surface portion of an adhesive temporary carrier 220 attached to a bottom main surface of said patterned electrically insulating layer structure 108. Thus, core 142 with through holes is placed on adhesive temporary carrier 220 to thereby form accommodation volumes for electronic components 110. Said accommodation volumes or cavities 126 are delimited by sidewalls of core 142 and an upper main surface portion of adhesive temporary carrier 220. As shown by arrows, electronic components 110 are then placed in the accommodation volumes and are attached on the adhesive temporary carrier 220. An uncured electrically insulating layer structure 108, for instance a continuous sheet of prepreg, and an electrically conductive layer structure 106, for example a copper foil, are then placed on core 142 and the electronic components 110. Thereafter, all mentioned constituents may be interconnected by lamination, i.e. the application of heat, for example temperatures larger than 70 °C, and/or pressure, for example larger than 1.5 bar.

Referring to **Figure 29****,** the electronic components 110 are fixed in place in the accommodation volumes or cavities 126 by laminating uncured further electrically insulating layer structure 108 on the electronic components 110. The temporary adhesive carrier 220 may then be removed from the structure obtained after lamination. Figure 29 may be an alternative to Figure 4. In Figure 29, an electrically conductive layer can be provided directly on the insulating layer structure 108 and the electronic components 110. This has the advantage to save one sinter layer as shown in Figure 4.

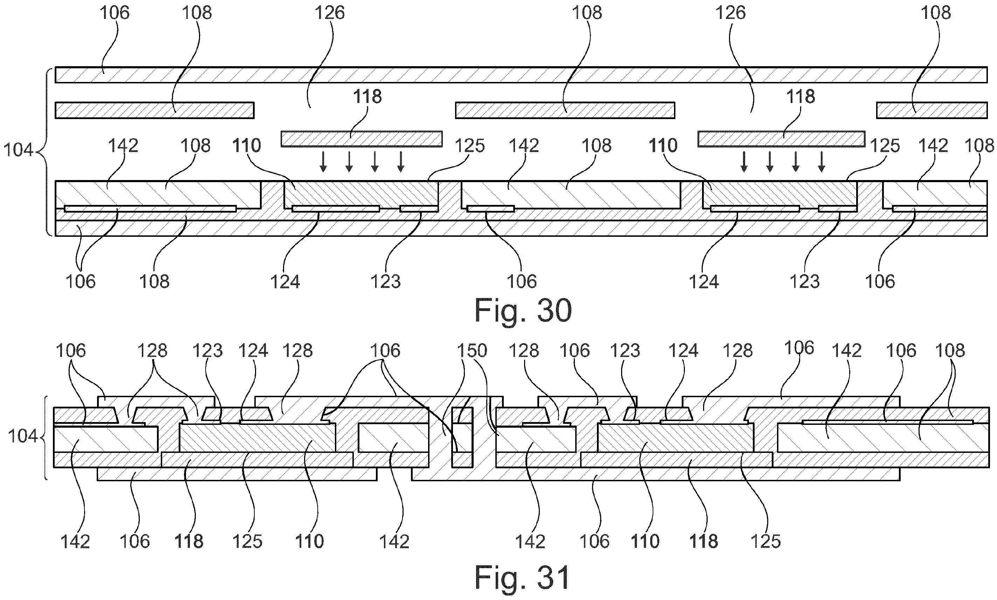

Referring to **Figure 30****,** the structure obtained after removal of the temporary carrier 220 may then be turned upside down. As indicated by arrows, a patterned conductive connection layer 118, such as a patterned layer of sinter paste, may then be attached to the exposed main surfaces of electronic components 110. Thus, after removing the temporary carrier 220, conductive connecting layer 118 embodied as a sinter paste is attached to an exposed main surface of the electronic components 110. An at least partially uncured electrically insulating layer structure 108, for instance a patterned sheet of prepreg having cavities 126, and an electrically conductive layer structure 106, for example a copper foil, are then placed on core 142 and patterned conductive connection layer 118. Thereafter, all mentioned constituents may be interconnected by lamination.

Alternatively, a conductive layer structure may be formed on the component 110 and the electrically insulating layer structure 108 (not shown). Thus, one sinter connection can be saved.

Referring to **Figure 31****,** the constituents of Figure 30 are shown upside down and interconnected after sinter lamination. Furthermore, an obtained structure may be subjected to drilling and plating. Drilling may form laser vias and/or mechanical vias in the obtained structure. Plating (for instance involving electroless plating for forming a seed layer and thereafter electroplating, for instance galvanic plating) may then be carried out for filling the laser-drilled and mechanically-drilled holes with metallic material such as copper. As a result, vertical connections 128 (in particular copper-filled laser vias) as well as vertical through connections 150 (in particular metal-filled mechanically drilled vias, or copper pillars) may be obtained. Thus, a central portion 104 of a stack 102 under manufacture is created.

The obtained structure may then be subjected to further processing according to Figure 5 to Figure 11 for completing manufacture of component carrier 100.

An advantage of the process according to Figure 28 to Figure 31 is that the arrangement and/or position between the sinter paste and the components 110 is very accurate. Due to a pick and place of the components 110 on the sinter paste (being omitted according to Figure 28 to Figure 31), there is the chance of a misalignment due to the pressing process, since the sinter paste is not (or not fully) cured at this stage when the component 110 is placed. No such issues or challenges occur in the embodiment according to Figure 28 to Figure 31.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention, whose scope is defined by the appended claims, even in the case of fundamentally different embodiments.

## Claims

1. A component carrier (100), wherein the component carrier (100) comprises:
a stack (102) having a central portion (104) comprising at least one electrically conductive layer structure (106) and at least one electrically insulating layer structure (108);
at least one electronic component (110) embedded in the central portion (104) of the stack (102); and
an electrically and thermally conductive first layer structure (112) on one side of the central portion (104) and an electrically and thermally conductive second layer structure (114) on an opposing other side of the central portion (104), each of said first layer structure (112) and said second layer structure (114) having a thickness (d1, d2) higher than a thickness (d3) of the at least one electrically conductive layer structure (106) of the central portion (104).

2. The component carrier (100) according to claim 1, wherein at least one of the first layer structure (112) and the second layer structure (114) comprises at least two sub-structures separated from each other.

3. The component carrier (100) according to claim 1 or 2, wherein the at least one electronic component (110) is electrically connected to one of the first layer structure (112) and the second layer structure (114).

4. The component carrier (100) according to any of claims 1 to 3, wherein the at least one electronic component (110) is electrically connected to a sub-structure of the first layer structure (112) and to a sub-structure of the second layer structure (114).

5. The component carrier (100) according to any of claims 1 to 4, comprising at least one conductive connecting layer (118-120), in particular an electrically conductive paste, connecting the at least one electronic component (110) with at least one of the first layer structure (112) and the second layer structure (114).

6. The component carrier (100) according to any of claims 1 to 5, comprising at least two conductive connecting layers (118-120) electrically connecting the at least one electronic component (110) with one of the first layer structure (112) and the second layer structure (114), wherein in particular one of said at least two conductive connecting layers (118-120) is directly connected to the at least one electronic component (110) and/or one of the at least one electrically conductive layer structure (106) of the stack (102) separates said at least two conductive connecting layers (118-120), wherein in particular the at least one electronic component (110) is electrically connected to the other one of the first layer structure (112) and the second layer structure (114) by a further conductive connecting layer (118-120), in particular being directly connected to the other one of the first layer structure (112) and the second layer structure (114).

7. The component carrier (100) according to any of claims 1 to 6, wherein the at least one electronic component (110) comprises at least two electronic components (110) embedded in the central portion (104), in particular connected with each other by at least one of the at least one electrically conductive layer structure (106) of the central portion (104), and/or wherein in particular the at least two electronic components (110) are connected with each other by one of the first layer structure (112) and the second layer structure (114), wherein more particularly said one of the first layer structure (112) and the second layer structure (114) is configured as a current port, in particular an alternating current port (122), and/or wherein in particular a top surface of a first of said electronic components (110) is electrically connected to a bottom surface of a second of said electronic components (110), in particular is electrically connected by at least one vertical through connection (150) at least partially extending through the central portion (104).

8. The component carrier (100) according to any of claims 1 to 7, wherein the at least one electronic component (110) comprises two main surfaces, one main surface comprising a conductive area (123), in particular two conductive areas (123, 124), and the other main surface comprising at least one further conductive area (125), wherein in particular at least one of the two conductive areas (123, 124) and the further conductive area (125) is connected to at least one of the first layer structure (112) and the second layer structure (114), in particular through at least one conductive connecting layer (118-120), more particularly through at least one conductive connecting layer (118-120) comprising a paste.

9. The component carrier (100) according to any of claims 1 to 8, comprising a vertical through connection (130) passing vertically through at least part of the stack (102) and being electrically connected to an electrically conductive area (123-125) of the at least one electronic component (110), wherein in particular the vertical through connection (130) forms a signal port (132) for providing a control signal to the at least one electronic component (110), and/or wherein in particular the vertical through connection (130) is electrically connected to the electrically conductive area (123-125) through at least one of the at least one electrically conductive layer structure (106), and/or wherein in particular the vertical through connection (130) is electrically insulated with respect to at least one of the first layer structure (112) and the second layer structure (114).

10. The component carrier (100) according to any of claims 1 to 9, wherein a thickness (d1, d2) of a respective one of the first layer structure (112) and the second layer structure (114) is in a range from 200 µm to 500 µm or is in a range from 400 µm to 1000 µm.

11. The component carrier (100) according to any of claims 1 to 10, wherein sub-structures of at least one of the first layer structure (112) and the second layer structure (114) are separated by at least one electrically insulating clearance structure (134), in particular so that a resulting electric path is exclusively for signal routing, wherein in particular the clearance structure (134) extends vertically up to the central portion (104) for completely separating sub-structures of at least one of the first layer structure (112) and the second layer structure (114), wherein more particularly the clearance structure (134) extends vertically into a part of at least one of the first layer structure (112) and the second layer structure (114).

12. The component carrier (100) according to any of claims 1 to 11, wherein at least one of the first layer structure (112) and the second layer structure (114) is formed by a patterned conductive layer provided on a respective side of the central portion (104), wherein in particular the patterned conductive layer comprises lateral walls with a vertically intermediate enlargement feature (154) between two vertical extremities (156, 158), and/or wherein in particular the patterned conductive layer comprises lateral walls having a concave shape, and/or wherein in particular the patterned conductive layer comprises lateral walls in accordance with the condition d≥T/4, wherein d is a horizontal offset of an extremity (158) of the patterned conductive layer on the central portion (104) of the stack (102) with respect to the opposed extremity (156) facing away from the central portion (104), and T is a thickness of the patterned conductive layer.

13. The component carrier (100) according to any of claims 1 to 12, comprising at least one vertical through connection (130) passing vertically through an electrically insulating clearance structure (134) in the second layer structure (114) for vertically electrically connecting at least one electrically conductive area (123-125) of the at least one electronic component (110).

14. The component carrier (100) according to claim 13, comprising at least one of the following features:
wherein the at least one electrically conductive area (123-125) of the at least one electronic component (110) comprises a gate pad and/or a source pad;
wherein the at least one vertical through connection (130) comprises two parallel vertical through connections (130) for vertically electrically connecting at least one, in particular two, electrically conductive areas (123, 124) on one main surface of one electronic component (110);
wherein the at least one vertical through connection (130) passes entirely vertically from an uppermost electrically conductive layer structure (106) of the stack (102) up to the at least one electrically conductive area (123-125);
wherein the at least one vertical through connection (130) comprises an electrically conductive sleeve (202) filled with an electrically conductive paste (200);
wherein the at least one vertical through connection (130) comprises electrically conductive paste (202) directly surrounded by the electrically insulating clearance structure (134).

15. A method of manufacturing a component carrier (100), wherein the method comprises:
providing a stack (102) having a central portion (104) comprising at least one electrically conductive layer structure (106) and at least one electrically insulating layer structure (108);
embedding at least one electronic component (110) in the central portion (104) of the stack (102); and
forming an electrically and thermally conductive first layer structure (112) on one side of the central portion (104) and an electrically and thermally conductive second layer structure (114) on an opposing other side of the central portion (104), each of said first layer structure (112) and said second layer structure (114) having a thickness (d1, d2) higher than a thickness (d3) of the at least one electrically conductive layer structure (106) of the central portion (104).
